# EUROPEAN PATENT APPLICATION

(11) **EP 2 056 064 A1**
(43) Date of publication of application: **06.05.2009**
(21) Application number: 07792381.1
(22) Date of filing: 10.08.2007
(51) Int. Cl.: G01B 11/24, G01N 21/956, H05K 3/34

(54) **INSPECTING APPARATUS, AND INSPECTING METHOD**

(30) Priority: 10.08.2006 JP 2006218931; 04.09.2006 JP 2006239036; 04.09.2006 JP 2006239068; 20.09.2006 JP 2006254175
(71) Applicant: I-Pulse Kabushiki Kaisha, Hamamatsu-shi, Shizuoka 431-2103 (JP)
(72) Inventor: KAKUDA, Yoshihisa, Hamamatsu-shi, Shizuoka 431-2103 (JP); NAKASHIMA, Tsutomu, Hamamatsu-shi, Shizuoka 431-2103 (JP)
(74) Representative: Müller-Boré & Partner Patentanwälte
(86) International application number: PCT/JP2007/065736
(87) International publication number: WO 2008/018591

(57) **Abstract**

An inspecting apparatus and an inspecting method capable of detecting a state inside the cream solder are provided.

An illumination device (5) irradiates infrared light at predetermined intensity to a board on which cream solder is applied. An image taking device (6) takes an image of the board to which the infrared light is irradiated. A main control portion (95) in a control device (9) is capable of detecting a sectional shape of the cream solder according to an intensity distribution of infrared light reflected on the board from image data of the image captured by the image taking device (6). Also, because reflected light from the cream solder surface can be eliminated by an elimination portion (95c), the sectional shape of the solder can be detected more exactly.

## Description

### Technical Field

The present invention relates to an inspecting apparatus and an inspecting method for inspecting a state of cream solder applied on a board.

### Background Art

There has been developed an inspecting apparatus that inspects a state of solder in order to stabilize the quality of a board on which electronic components are mounted.

For example, Japanese Unexamined Patent Publication No. HEI9-89536 discloses a method for a board on which a semiconductor device is mounted to inspect solder formed between the semiconductor device and the board. According to this method, light including a wavelength in an infrared range is irradiated to the board to detect reflected light at the wavelength in the infrared range having passed through a polyimide board and reflected on the solder surface using a camera. An image density signal is then obtained by converting the resulting image signal data into a digital form through A-to-D conversion. A state of the solder is detected by measuring an area made up of pixels each having a density value larger than the pre-set density value within a predetermined region.

Also, Japanese Unexamined Patent Publication No. 2002-280727 discloses a method for inspecting a state of solder formed on the board on the basis of an X-ray transmission image. According to this method, an X-ray is irradiated to the board to detect an X-ray transmission image having passed through the board. A state of the solder is detected on the basis of the X-ray transmission image.

### Disclosure of the Invention

The method disclosed in the Patent Publication No. HEI9-89536 is to irradiate light to a polyamide board after the process of junction formation, namely, reflow, and is not intended for application to an inspecting apparatus that inspects a state of cream solder applied on the board. In addition, this method is to detect a state of solder on the basis of reflected light from the solder surface. Accordingly, although it is possible to inspect a state on the solder surface, it is impossible to inspect a state inside the solder or a three-dimensional shape thereof.

Meanwhile, it is possible to inspect a state inside the solder using the method disclosed in the Patent Publication No. 2002-280727. The use of X-rays, however, raises problems, such as the apparatus is expensive and the size of the apparatus is large due to the need to install X-ray shielding equipment.

The invention of the present application has been worked out to solve the problems discussed above and has an object to provide an inspecting apparatus and an inspecting method which can detect a state inside cream solder more readily in a case where a state of cream solder applied on a board is inspected.

In order to achieve the above and other objects, an inspecting apparatus of the invention includes: an illuminator for irradiating infrared light at predetermined intensity to a board on which cream solder is applied; an image obtainer having an image taking device for taking an image of the board to which the infrared light is irradiated for obtaining an image indicating an intensity distribution of infrared light reflected on the board; and a detector for detecting a sectional shape or a three-dimensional shape of the cream solder based on the image.

According to the invention, by irradiating infrared light at predetermined intensity to a board on which cream solder is applied to take an image of the board and by detecting the sectional shape or the three-dimensional shape of the cream solder from reflected light from an electrode pad in the image thus taken, it becomes possible to detect a state inside the cream solder without having to use an X-ray as in the related art, which can in turn reduce the cost and the size of the apparatus. Consequently, a state inside the cream solder can be detected more readily.

### Brief Description of the Drawings

Fig. 1 is a front view showing an external appearance of an inspecting apparatus of the invention.
Fig. 2 is a plan view showing an internal configuration of the inspecting apparatus of the invention.
Fig. 3 is a block diagram showing the configuration of a control system in the inspecting apparatus of the invention.
Fig. 4 is a diagram schematically showing the configuration of an image taking unit.
Fig. 5 is a diagram schematically showing the configuration of cream solder.
Fig. 6A is an image of reflected light when infrared light is irradiated to a board on which cream solder is applied using a 50-µm-thick screen and Fig. 6B is a graph showing the light intensity distribution in the case of Fig. 6A.
Fig. 7A is an image of reflected light when infrared light is irradiated to a board on which cream solder is applied using a 70-µm-thick screen and Fig. 7B is a graph showing the light intensity distribution in the case of Fig. 7A.
Fig. 8A is an image of reflected light when infrared light is irradiated to a board on which cream solder is applied using a 100-µm-thick screen and Fig. 8B is a graph showing the light intensity distribution in the case of Fig. 8A.
Figs. 9A through 9C are diagrams each schematically showing a vertical cross section of cream solder.
Figs. 10A through 10C are diagrams schematically showing images of reflected light when infrared light at the same intensity is irradiated to the cross sections of Figs. 9A through 9C, respectively.
Fig. 11 is a graph showing a relation between the thickness of cream solder and brightness of pixels.
Fig. 12 is a diagram showing an image of reflected light when intensity of infrared light is changed.
Fig. 13 is a flowchart detailing an inspection operation.
Fig. 14 is a graph showing a relation between a supply voltage to an infrared LED and light intensity irradiated from the infrared LED.
Fig. 15 is a graph showing a relation between light intensity of infrared light and light intensity of surface reflected light.
Fig. 16 is a diagram schematically showing a modification of an image taking unit.
Fig. 17 is a diagram schematically showing a state where an illumination device 5 and an image taking device 6 are provided diagonally.
Fig. 18A is a diagram schematically showing a state where infrared light is irradiated to a board in a direction perpendicular to the board and Fig. 18B is a diagram schematically showing a state where infrared light is irradiated to the board diagonally.
Fig. 19 is a block diagram showing the configuration of an inspecting apparatus according to a second embodiment.
Fig. 20 is a flowchart detailing an inspection operation according to the second embodiment.
Fig. 21 is a block diagram showing the configuration of a control system in an inspecting apparatus according to a third embodiment.
Fig. 22 is a flowchart detailing an inspection operation according to the third embodiment.
Fig. 23 is a diagram schematically showing image data converted into a binary form.
Fig. 24 is a block diagram showing the configuration of a control system in an inspecting apparatus according to a fourth embodiment.
Fig. 25 is a flowchart detailing an inspection operation according to the fourth embodiment.
Fig. 26 is a flowchart detailing a first image processing according to the fourth embodiment.
Fig. 27 is a flowchart detailing a second image processing according to the fourth embodiment.
Fig. 28 is a flowchart detailing a third image processing according to the fourth embodiment.
Fig. 29 is a flowchart detailing a conformity and non-conformity determination processing according to the fourth embodiment.

### Best Mode for Carrying Out the Invention

### First Embodiment

Hereinafter, a first embodiment of the invention will be described in detail with reference to the drawings.

### Configuration of Inspecting Apparatus

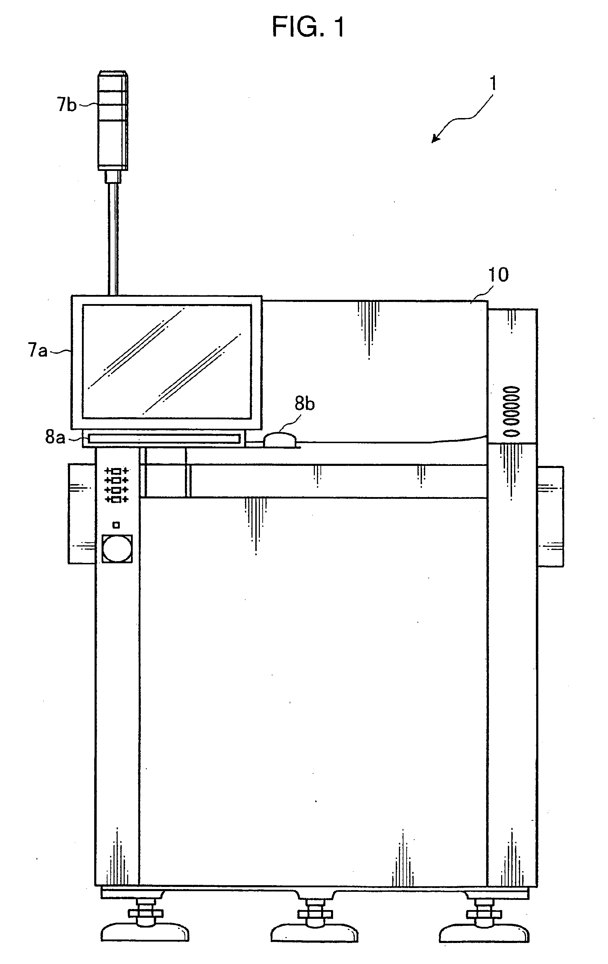

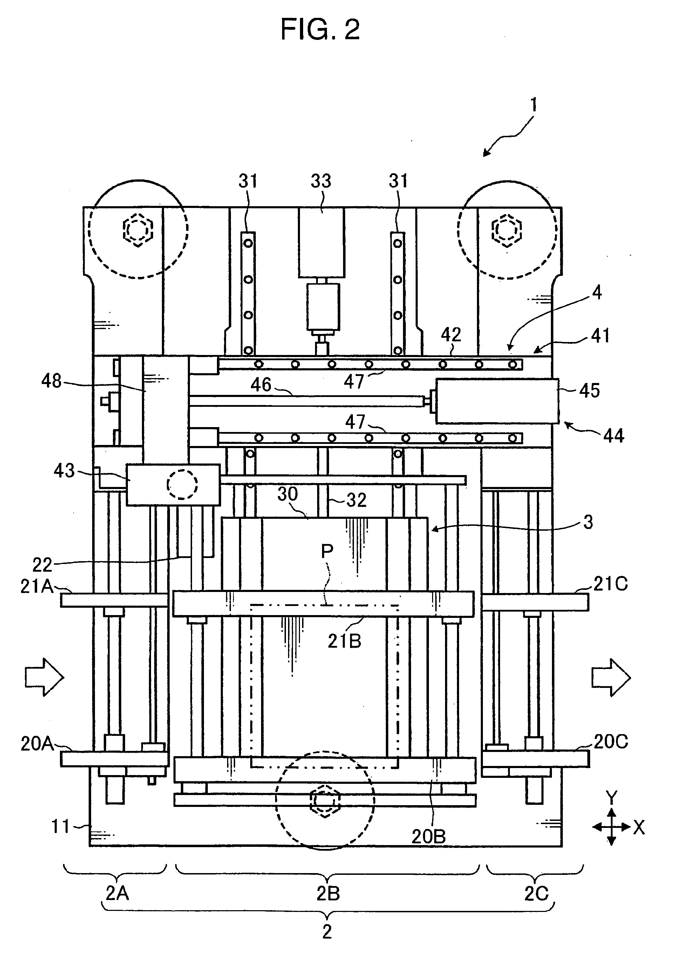

As are shown in Fig. 1 and Fig. 2, an inspecting apparatus 1 of this embodiment is covered by a cover 10 almost in the shape of a square prism as a whole and has a hollow base stand 11 almost in the shape of a square prism inside the cover 10. As shown in Fig. 1 through Fig. 3, the inspecting apparatus 1 configured as above includes a board transportation portion 2, a table transportation 3, an image taking device transportation portion 4, an illumination device 5 (illuminator), an image taking device 6, a display device 7, an input device 8, and a control device 9.

As shown in Fig. 2, the board transportation portion 2 is provided on the base stand 11 to transport a printed wiring board P (hereinafter, referred to as the board P) as a subject to be inspected, and it is comprised by three parts each having a pair of belt conveyors and aligned side by side in the X-axis direction. Specifically, it has carry-in and carry-out portions 2A and 2C respectively having belt conveyors 20A and 21A and belt conveyors 20C and 21C in predetermined ranges on the both sides of the inspecting apparatus 1 in the board transportation direction and has a movable portion 2B having belt conveyors 20B and 21B on a table 30 described below between the carry-in and carry-out portions 2A and 2C. In this embodiment, the transportation direction of the board P (the right-left direction in Fig. 2) is defined as the X-axis and a direction orthogonal to the X-axis on a horizontal plane (the top-bottom direction in Fig. 2) is defined as the Y-axis direction.

Regarding the carry-in and carry-out portions 2A and 2C, the conveyors 20A and 20C on the front side are provided immovably onto the base stand 11, whereas the conveyers 21A and 21C on the rear side are provided in a movable manner in the Y-axis direction. The interval between conveyors can be adjusted according to the size of the board P by moving the conveyers 21A and 21C on the rear side that are driven by a motor (not shown).

The movable portion 2B is provided with a pair of conveyors 20B and 21B on the table 30 movable in the Y-axis direction. Of these belt conveyors, the conveyor 20B on the front side is fixed to the table 30 whereas the conveyor 21B on the rear side is supported on the table 30 in a movable manner in the Y-axis direction. The interval between the conveyors 20B and 21B varies in association with movements of the conveyor 21B on the rear side that is driven by a motor (not shown) so as to be adjustable in response to a size change of the board P.

A transportation belt (not shown) is looped over pulleys in each of the conveyors 20A, 21A, 20B, 21B, 20C, and 21C. When the conveyors 20B and 21B of the movable portion 2B are at positions corresponding to the other conveyors 20A, 21A, 20C, and 21C (when the table 30 is at the front edge position in the movable range), the respective transportation belts are driven by a motor 22 provided to the table 30 to move in association for the board P to be transported.

By adopting the configuration as above, the board P is carried into the inspecting apparatus main body 1 from the left side of the apparatus along the conveyors of the board transportation portion 2, and carried out from the right side of the apparatus to the following process after it is subjected to inspection processing in an inspection work area provided almost at the center of the base stand 11 (a direction indicated by hollow arrows in the drawing).

As shown in Fig. 2, the table transportation portion 3 includes the table 30 of almost a rectangular shape when viewed in a plane, a pair of guide rails 31 fixed onto the base stand 11 along the Y-axis direction, a ball screw shaft 32 provided along the Y-axis direction and supported on the base stand 11 in a rotatable manner, and a motor 33 to which one end of the ball screw shaft 32 is connected. Herein, the table 30 is provided to be movable along the guide rails 31 and has a nut portion (not shown) threaded into the ball screw shaft 32. Accordingly, the table transportation portion 3 moves the table 30 in the Y-axis direction along the guide rails 31 by driving the ball screw shaft 32 to rotate using the motor 33.

As shown in Fig. 2, the image taking device transportation portion 4 includes a gate-type supporting stand 41 provided to stand on the stand surface of the base stand 11 at a position slightly closer to the rear side with respect to the center portion in the front-rear direction of the base stand 11 (the top-bottom direction in Fig. 2). The supporting stand 41 is comprised by pillar portions (not shown) respectively standing up from the both end portions in the right-left direction and a beam portion 42 bridging between the upper end portions of the pillar portions. The beam portion 42 of the supporting stand 41 is provided with an image taking unit 43 having the illumination device 5 and the image taking device 6 to take an image of the board P and a drive device 44 that moves the image taking unit 43 along the supporting stand 41. The drive device 44 has a motor 45 provided on the beam portion 42 of the supporting stand 41, a ball screw shaft 46 coupled to the output shaft of the motor 45 and extending in the right-left direction, and a pair of guide rails 47 provided on the beam portion 42 in parallel with the ball screw shaft 46. Herein, the image taking unit 43 is supported on a supporting frame 48 threaded into the ball screw shaft 46. Accordingly, the image taking device transportation portion 4 moves the image taking device 6 together with the supporting frame 48 as one unit in the X-axis direction along the guide rails 47 by driving the motor 45.

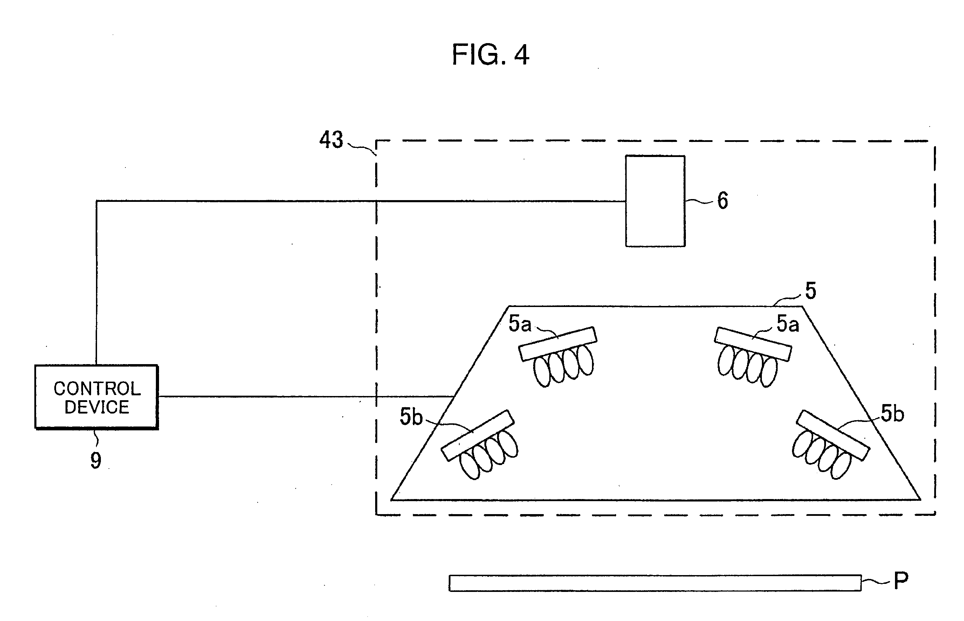

The illumination device 5 is comprised by an illuminating device that outputs infrared light, such as an infrared LED (Light Emitting Diode), and driven on a voltage supplied from the control device 9 (hereinafter, referred to as the supply voltage). For example, As shown in Fig. 4, the illumination device 5 configured as above together with the image taking device 6 is provided above the board P as the image taking unit 43 in a movable state by the image taking device transportation unit 4. Herein, infrared LED's 5a forming the illumination device 5 are provided above the board P in such a manner that the optical axis has an angle of 10 degrees ± 6 degrees with respect to an axis perpendicular to the principal surface of the board P. As shown in Fig. 4, in a case where a pair of infrared LED's 5a is provided, each may be provided to be line symmetrical with respect to the perpendicular axis. The illumination device 5 configured as above is able to output infrared light at a wavelength of 875 ± 30 nm. Also, As shown in Fig. 4, besides the infrared LED's 5a, the illumination device 5 may be provided with visible-light LED's 5b that irradiate visible light.

The image taking device 6 is comprised by a CCD (Charge Coupled Device) camera or the like and has wavelength sensitivity in the infrared range. The image taking device 6 takes an image according to an instruction from the control device 9. For example, As shown in Fig. 4, the image taking device 6 configured as above together with the illumination device 5 is provided above the board P as the image taking unit 43 in a state movable by the image taking device transportation portion 4.

The display device 7 is comprised by a known display device, such as a CRT (Cathode Ray Tube), an LCD (Liquid Crystal Display), and an FED (Field Emission Display), or a known signal tower. The display device 7 as above displays various types of information thereon according to an instruction from the control device 9. In this embodiment, As shown in Fig. 1, it is comprised by a display 7a provided to the side face of the cover 10 and a signal tower 7b protruding upward from the top face of the cover 10.

The input device 8 is comprised by a device that detects an input of information from the outside, such as a keyboard, a mouse, a pointing device, a button, and a touch panel. Information detected by the input device 8 is inputted into the control device 9. In this embodiment, As shown in Fig. 1, it is comprised by a keyboard 8a and a mouse 8b both provided in the vicinity of the display 7a.

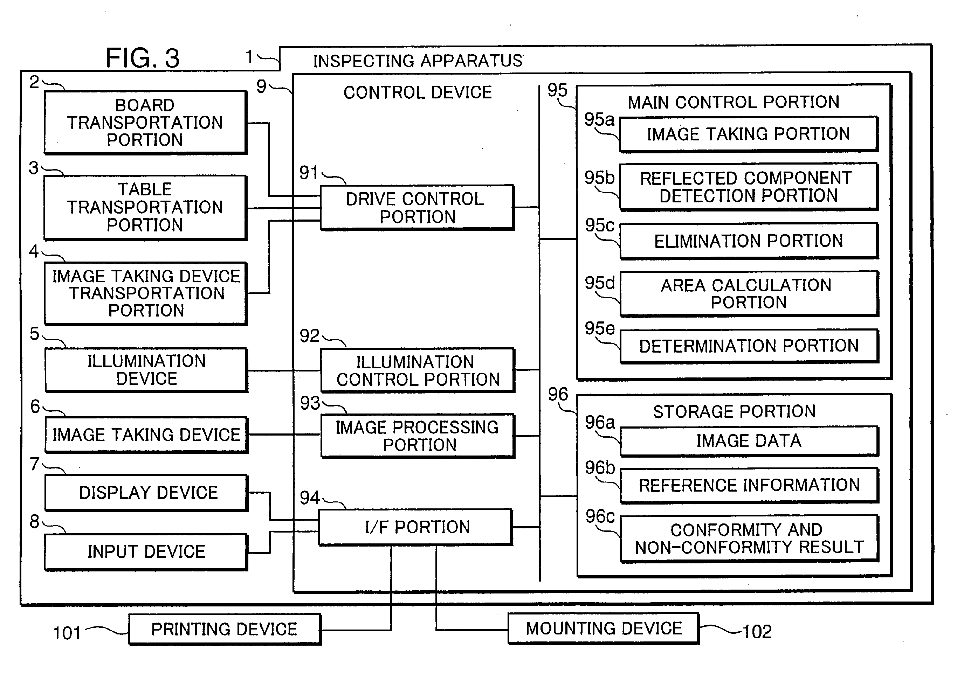

The control device 9 is a device that controls an overall operation of the inspecting apparatus 1. As shown in Fig. 3, it includes a drive control portion 91, an illumination control portion 92, an image processing portion 93, an I/F portion 94, a main control portion 95, and a storage portion 96.

The drive control portion 91 is a functional portion that generates and outputs drive signals according to an instruction from the main control portion 95 to drive the motor (not shown) and the motor 22 of the board transportation portion 2, the motor 33 of the table transportation portion 3, and the motor 45 of the image taking device transportation portion 4. Owing to this configuration, the board P, the table 30 or the image taking unit 43 is allowed to move.

The illumination control portion 92 is a functional portion that sets the supply voltage corresponding to light intensity of infrared light irradiated from the illumination device 5 and outputs the supply voltage to the illumination device 5 according to an instruction from the main control portion 95. Owing to this configuration, the illumination device 5 becomes able to output infrared light at the predetermined intensity.

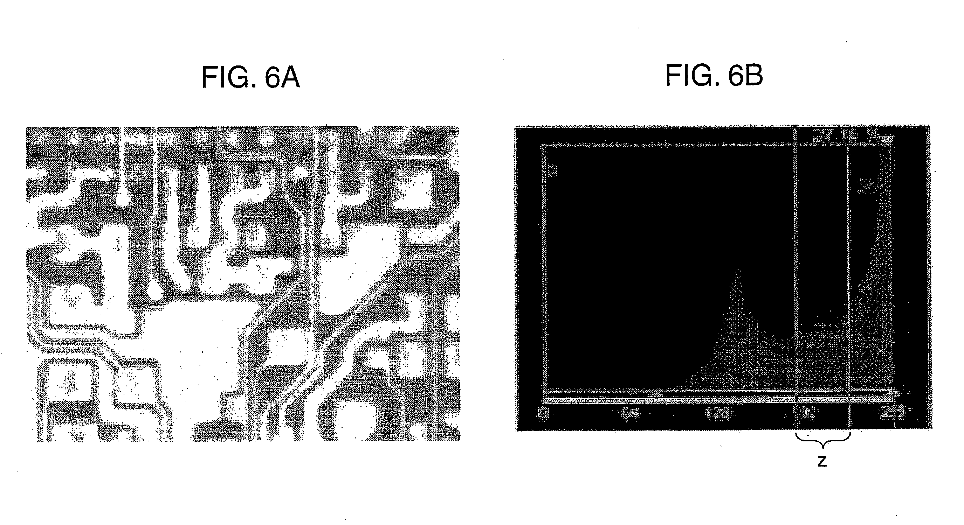

The image processing portion 93 is a functional portion that outputs an instruction to take an image to the image taking device 6 according to an instruction from the main control portion 95 and applies image processing, such as A-to-D conversion, to a captured image taken by the image taking device 6 according to the instruction it has outputted for outputting the resulting image data. Consequently, for example, As shown in Fig. 6, image data expressing light intensity of reflected light for each pixel in gradation can be generated.

The I/F portion 94 activates the display device 7 to display various types of information according an instruction from the main control portion 95. Further, it transmits various types of information detected by the input device 8 to the main control portion 95. In addition, it performs transmission and reception of various types of information with a printing device 101 that prints cream solder on the board and with a mounting device 102 that mounts electronic components on the board after the inspection is performed thereon by the inspecting apparatus 1.

The main control portion 95 is a functional portion that achieves an inspection operation to inspect a state of cream solder printed on the board by outputting instructions to the illumination control portion 92, the image processing portion 93, the drive control portion 91, and the I/F portion 94 according to an instruction from the outside, for example, from the user, the host computer, or the like. The main control portion 95 configured as above includes an image taking portion 95a that activates the image taking device 6 to take an image of the board on which cream solder is applied, a reflected component detection portion 95b that detects a reflected component of infrared light from the cream solder surface in the image data, an elimination portion 95c (eliminator) that eliminates the reflected component from the image data, an area calculation portion 95d that calculates the sectional area by detecting the sectional shape of the cream solder based on the image data from which the reflected component has been eliminated by the elimination portion 95c, and a determination portion 95e that determines conformity or non-conformity of the cream solder on the basis of the calculated sectional area of the cream solder.

The image taking device 6, the image processing portion 93, and the image taking portion 95a, the reflected component detection portion 95b, and the elimination portion 95c in the main control portion 95 together form image obtainer for obtaining an image indicating the intensity distribution of infrared light reflected on the board P (in particular, an image from which the reflected component from the surface of the cream solder has been eliminated and thereby indicating the intensity distribution of infrared light reflected on the board P). Also, the area calculation portion 95d forms detector for detecting the sectional shape of the cream solder based on the image.

The storage portion 96 is a functional portion that stores various types of information to achieve operations of the inspecting apparatus 1. The storage portion 96 stores at least a captured image taken by the image taking device 6, image data generated by the image processing portion 93, image data 96a, such as image data from which the reflected component has been eliminated by the elimination portion 95c, reference information 96b relating to a threshold value used when the determination portion 95e determines conformity or non-conformity of the cream solder, and a determination result 96c of the determination portion 95e.

The control device 9 configured as above is comprised by a computer including a computing unit, such as a CPU, a storage device, such as a memory and an HDD (Hard Disc Drive), and an I/F device that performs transmission and reception of various types of information via a communication line, such as the Internet, and a LAN (Local Area Network), a WAN (Wide Area Network), and programs installed in the computer. More specifically, the hardware resources specified above are controlled by the programs as the hardware device and software operate in cooperation so as to achieve the drive control portion 91, the illumination control portion 92, the image processing portion 93, the I/F portion 94, the main control portion 95, and the storage portion 96. The programs may be provided in a state where they are recorded in a recoding medium, such as a flexible disc, a CD-ROM, a DVD-ROM, and a memory card.

### Operation Principle

The operation principle of the inspecting apparatus 1 of this embodiment will now be described.

Cream solder is formed of solder powder and flux. Solder powder and flux are kneaded sufficiently into paste in which solder powder is diffused almost uniformly in the flux. By irradiating infrared light to the board on which such cream solder is applied, a part of the infrared light is reflected on the cream solder surface and on the solder powder near the surface and another part travels in the cream solder while passing through the flux in the cream solder until it reaches an electrode pad formed of a metal layer to be reflected on the electrode pad. The reflected light passes through the flux F in the cream solder again and infrared light coming out to the outside of the cream solder is detected by the image taking device 6.

While infrared light passes through the cream solder in this manner, it is scattered by the solder powder or attenuated by the flux. Accordingly, as the cream solder becomes thicker, infrared light passes through inside the cream solder over a longer distance. More components are therefore scattered or attenuated and light intensity of reflected light consequently becomes lower.

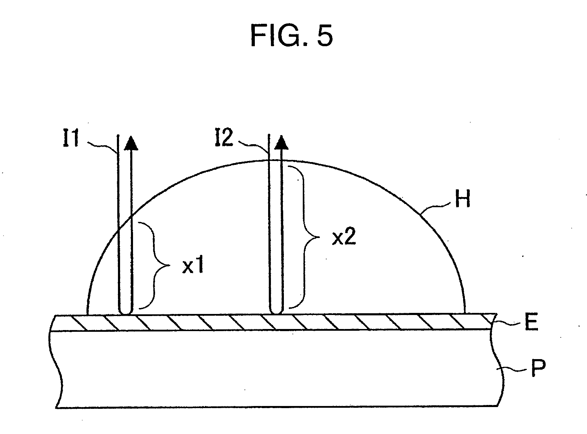

For example, as shown in Fig. 5, with cream solder H applied over an electrode pad E on the board P and having an almost semicircular cross section, assume that infrared light I1 is irradiated to the cream solder H on the rim and infrared light I2 is irradiated to the cream solder H at the center. In this instance, because the infrared I1 passes through from the surface of the cream solder H to the electrode pad D over a short distance x1, a small amount of components are scattered or attenuated. Light intensity of reflected light thus becomes high. On the contrary, because the infrared I2 passes through from the surface of the cream solder H to the electrode pad D over a long distance x2, a large amount of components are scattered or attenuated. Light intensity of reflected light thus becomes low.

Fig. 6A, Fig. 7A, and Fig. 8A show images of boards taken by the image taking device 6 when infrared light set at predetermined intensity was irradiated to boards on which cream solder was printed by means of screen printing by setting the thickness of the screen to 50 µm, 70 µm, and 100 µm, respectively. Fig. 6B, Fig. 7B, and Fig. 8B indicate the number of pixels at each density level when light intensity of each pixel forming the images of Fig. 6A through Fig. 8A is represented by 256-level gradation. In Fig. 6A, Fig. 7A, and Fig. 8A, the brightness of each pixel represents light intensity of infrared light reflected on the board surface. The image is therefore shown whiter as the intensity becomes higher and blacker as the intensity becomes lower.

As are shown in Fig. 6A, Fig. 7A, and Fig. 8A, silicon forming the board is shown in black because it transmits infrared light and reflected light is hardly produced. The electrode pad formed on the board is shown in white because it reflects infrared light.

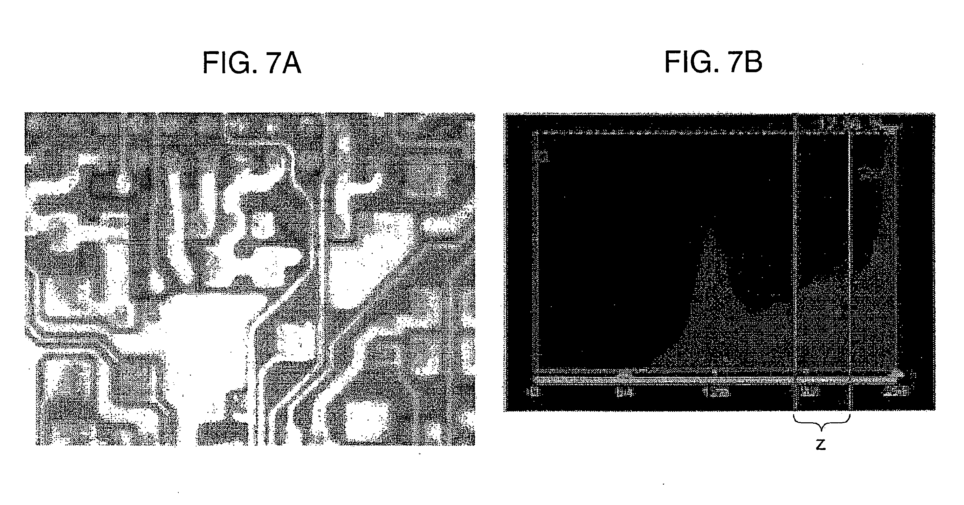

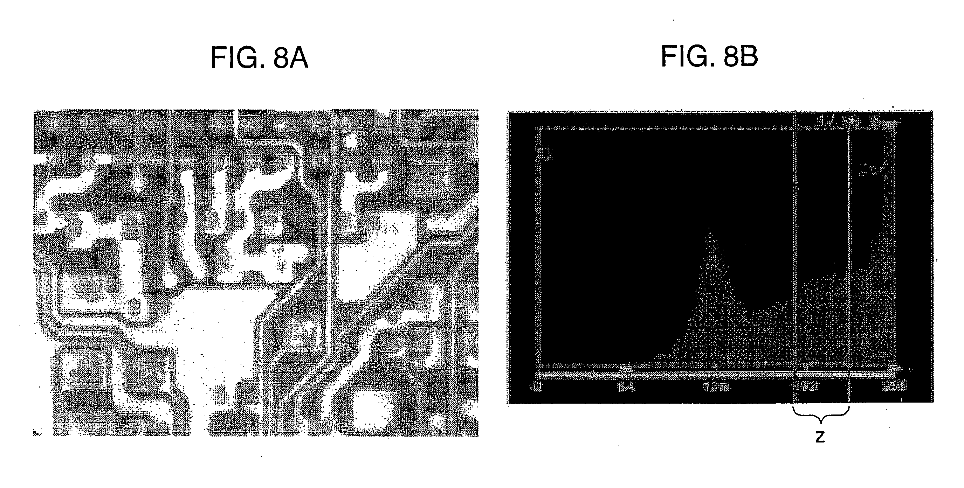

In a case where the cream solder is thick as in Fig. 7A and Fig. 8A (70 µm and 100 µm, respectively), because light intensity of reflected light becomes low, the cream solder on the electrode pad is shown in black. Also, as are shown in Fig. 7B and 8B, the number of pixels at brightness corresponding to the cream solder expressed in the range z is increased.

On the contrary, in a case where the cream solder is thin as in Fig. 6A (50 µm), because light intensity of reflected light is high, the cream solder is shown in white. This makes it impossible to distinguish between the cream solder and the electrode pad. As shown in Fig. 6B, the number of pixels in the range z is smaller.

As has been described, because light intensity of reflected light varies with the thickness of the cream solder, it is possible to detect the sectional shape of the cream solder from the intensity distribution of reflected light, that is, brightness of the image. More specifically, infrared light is thought to have passed through the cream solder over the same distance in portions of pixels at the same brightness. Hence, it can be said that the thicknesses of the cream solder are equal. Also, it can be said that a region at certain brightness or below is a region over which the cream solder is applied in a certain thickness or more.

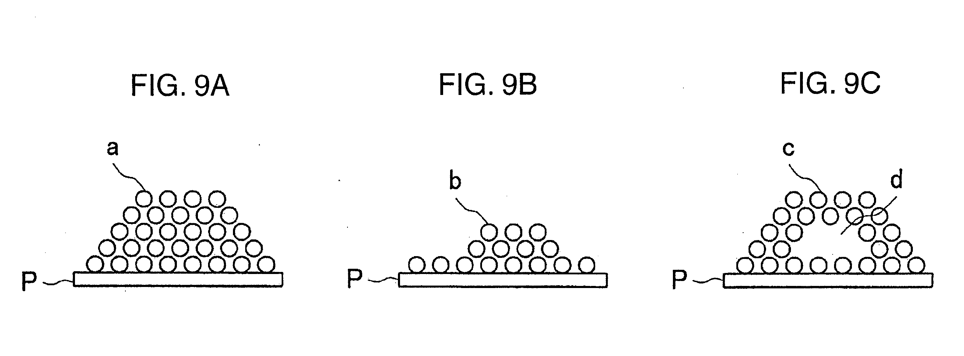

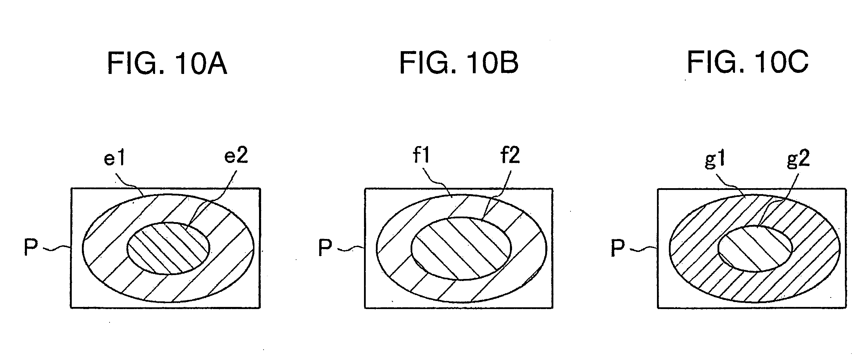

Accordingly, in a case where cream solder applied on the boards P has cross sections (in a direction perpendicular to the board surface) as shown, for example, in Fig. 9A through Fig. 9C, when images of the boards P are taken by irradiating infrared light at predetermined intensity to the boards P, the resulting images are as those shown in Fig. 10A through Fig. 10C, respectively. For the boards P shown in Fig. 9 and Fig. 10, metal plating corresponding to the electrode pad is applied across the entire top surface and cream solder is applied on the electrode pad within a predetermined range.

Specifically, As shown in Fig. 9A, in a case where cream solder a is applied in a truncated conical shape, infrared light passes through inside the cream solder over a long distance in a plane region at the center of the truncated cone of the cream solder and passes through inside the cream solder over a shorter distance as the irradiated spot is moved from the center toward the periphery. Fig. 10A shows a captured image when taking an image of the board P on which the cream solder a as above is applied. Specifically, because infrared light does not pass through inside the cream solder in a portion corresponding to the electrode pad on the outer periphery of the cream solder a, this portion is shown most brightly. Because a distance over which infrared light passes through inside the cream solder becomes longer as the irradiated spot is moved toward the center in a portion (indicated by reference alpha-numeral e1) from the rim of the cream solder a toward the center of the cream solder a, this portion is shown darker toward the center. Because the distance over which infrared light passes through inside the cream solder is the longest at the center (indicated by reference alpha-numeral e2) of the cream solder a, this portion is shown most darkly.

Meanwhile, in a case where cream solder b is applied thinner than the cream solder a As shown in Fig. 9B, a distance over which infrared light passes through inside the cream solder becomes shorter. Hence, as shown in Fig. 10B, the cream solder b is shown as an image of a dark portion (indicated by reference alpha-numeral f1) that is brighter than the dark portion e1 shown in Fig. 10A. In the dark portion f1, because the thickness of the cream solder is thicker at the center (indicated by reference alpha-numeral f2) than on the rim, a distance over which infrared light passes through inside the cream solder becomes longer. The center portion is thus shown darker than the dark portion fl.

Also, in a case as shown in Fig. 9C where an air bubble d is present inside cream solder c of a truncated conical shape, infrared light passing through a region corresponding to the air bubble d passes through inside the cream solder over a shorter distance. Fig. 10C shows a captured image when taking an image of the cream solder c as above. Specifically, a portion corresponding to the electrode pad on the outer periphery of the cream solder c is shown most brightly. Because infrared light passes through inside the cream solder over a longer distance as the irradiated spot is moved toward the center in a portion (indicated by reference alpha-numeral g1) from the rim of the cream solder c toward the center of the cream solder, this portion is shown darker toward the center. In particular, the region adjacent to the center is shown most darkly. Because infrared light passes through inside the cream solder over a shorter distance due to the air bubble at the center (indicated by reference alpha-numeral g2) having the air bubble d, this portion is shown brighter than the portion adjacent to the center within the portion indicated by reference alpha-numeral g1.

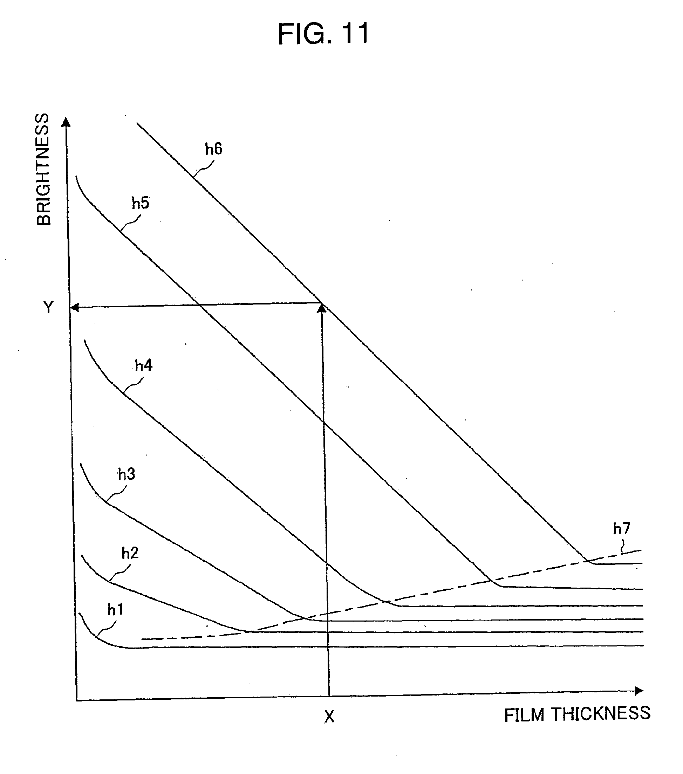

The sectional shape of the cream solder in the predetermined thickness can be detected, for example, by preparing the characteristic diagram as shown in Fig. 11. Fig. 11 is a relationship diagram of the film thickness of cream solder and the brightness of pixels (in the characteristic diagram of Fig. 11, the brightness is raw brightness imaged by the image taking device 6 without any processing and including infrared light reflected on the board surface and reflected components from the cream solder surface) when rays of infrared light at a plurality of light intensities (given as h1, h2, and so forth, indicating that light intensity outputted from the infrared LED 5a becomes higher with the attached figures) are irradiated to boards on which cream solder in known film thickness is applied. Referring to this characteristic diagram, each of the curves h1 through h6 indicates that reflected components from the board surface are reduced as the thickness increases and there are only reflected components from the cream solder surface when the film thickness exceeds the predetermined thickness. Eventually, each stays at almost constant brightness. Also, each indicates that light intensity of reflected light becomes higher at the predetermined thickness X (not only reflected components from the board surface but also reflected components from the surface of cream solder are increased) as light intensity of the infrared LED 5a serving as the light source becomes higher.

For example, in a case where a cross section in the thickness X needs to be detected when infrared light at intensity corresponding to the curve h6 is irradiated, a pixel corresponding to the cross section in the thickness X can be detected as being a pixel at brightness Y from the inclination of the curve h6. Accordingly, by detecting pixels at the brightness Y or pixels at the brightness Y or below, it becomes possible to detect the cross section in the thickness X.

As has been described, according to this embodiment, by taking an image of a board perpendicularly from above in a state where infrared light having a synthesized direction perpendicular to the board is irradiated to the board on which cream solder is applied, it becomes possible to detect the sectional shape of a plane (a plane spaced apart from the board P) of the cream solder parallel to the board based on the image indicating the intensity distribution of reflected light from the board.

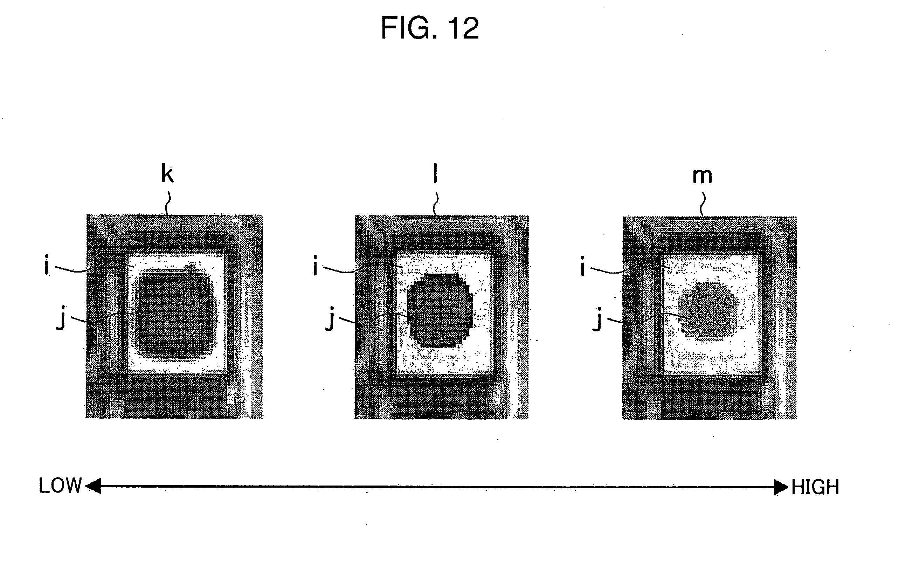

The intensity of reflected light is in proportion to intensity of infrared light to be irradiated. For example, As shown in Fig. 12, intensity of reflected light becomes higher as intensity of infrared light increases. Accordingly, pixels corresponding to cream solder become brighter. Specifically, cream solder j on the electrode pad i becomes brighter as intensity of infrared light increases from an image k to an image m. Hence, it can be said that even the images are at the same brightness, the cream solder is thicker in a portion where intensity of the infrared light to be irradiated is higher.

Incidentally, when infrared light is irradiated to a board on which cream solder is applied, as has been described, the infrared light passes through the flux, and not only is it reflected on the electrode pad or the like on the board, but it is also reflected on the cream solder surface. The image taking device 6 therefore takes an image of reflected light having passed through the flux and reflected on the board or the like (hereinafter, referred to as the transmitted reflected light) as well as an image of reflected light from the cream solder surface and from the solder powder near the surface (hereinafter, referred to as the surface reflected light). Accordingly, light intensity of each pixel forming an image taken by the image taking device 6 is not the value of light intensity of the transmitted reflected light, which makes it difficult to detect an exact sectional shape of the cream solder. In this embodiment, in order to detect an exact sectional shape of the cream solder, components of the surface reflected light are detected in the image taken by the image taking device 6 and the image of the transmitted reflected light alone is obtained by eliminating these reflected components.

### Operation of Inspecting Apparatus

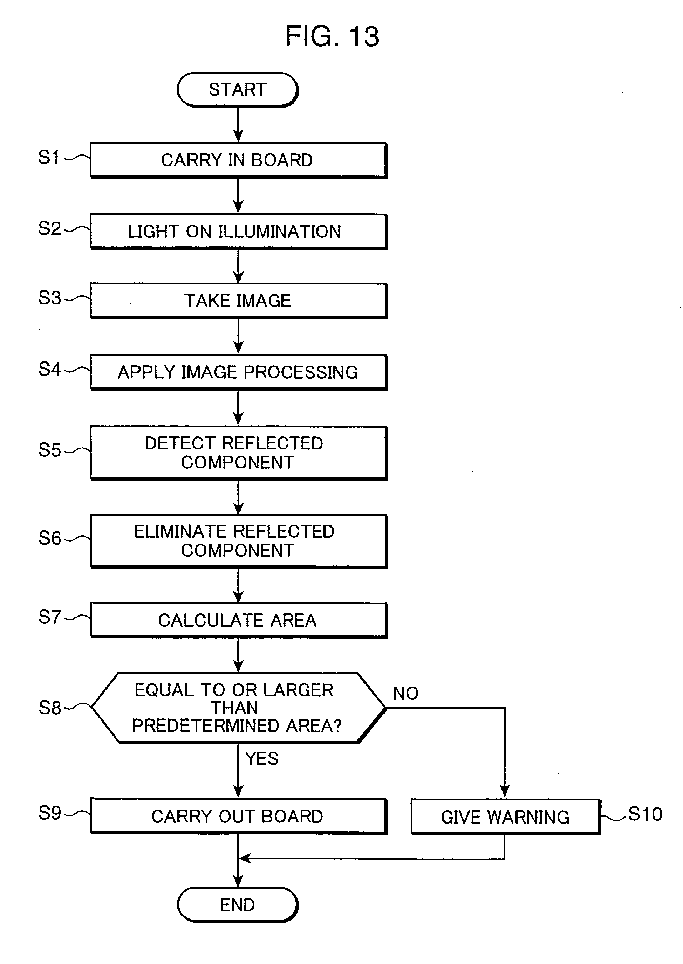

An inspection operation by the inspecting apparatus 1 of this embodiment will now be described with reference to Fig. 13.

Initially, the image taking portion 95a in the main control portion 95 activates the drive control portion 91 to drive the board transportation portion 2, so that a board on which cream solder is applied by the printing device 101 is carried in and disposed at the predetermined position on the table 30 (Step S1).

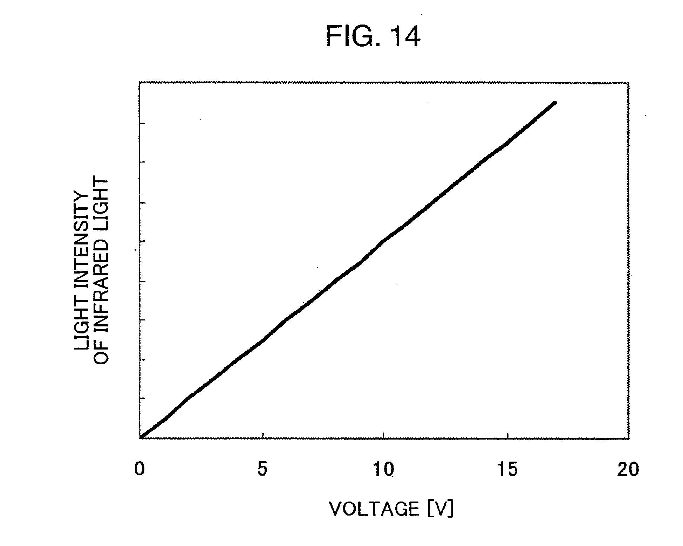

When the board is carried in at the predetermined position, the image taking portion 95a activates the drive control portion 91 to drive the table transportation portion 3 and the image taking device transportation portion 4, so that the image taking unit 43 is disposed above the board, while it activates the illumination control portion 92 for driving the illumination device 5 to irradiate infrared light at the predetermined intensity to the board (Step S2). Herein, intensity of the infrared light is set as needed according to the thickness of the cream solder applied on the board or the like. As shown in Fig. 14, intensity of infrared light is in proportion to the supply voltage to the infrared LED. Accordingly, when intensity of infrared light to be irradiated from the illumination device 5 is set by the image taking portion 95a according the thickness of cream solder applied on the board, the illumination control portion 92 sets the value of the supply voltage to the illumination device 5 according to the intensity thus set. Information about the thickness of the cream solder can be acquired from the input device 8, the printing device 101, or the like.

When infrared light is irradiated, the image taking portion 95a activates the image processing portion 93 for driving the image taking device 6 to take an image of the board to which the infrared light is irradiated (Step S3).

When the image is captured by the image taking device 6, the image taking portion 95a activates the image processing portion 93 to apply image processing on the captured image to generate image data (Step S4).

When the image data is generated, the reflected component detection portion 95b in the main control portion 95 detects reflected components of the infrared light from the cream solder surface in the image data (Step S5). The reflected components can be detected by the following method.

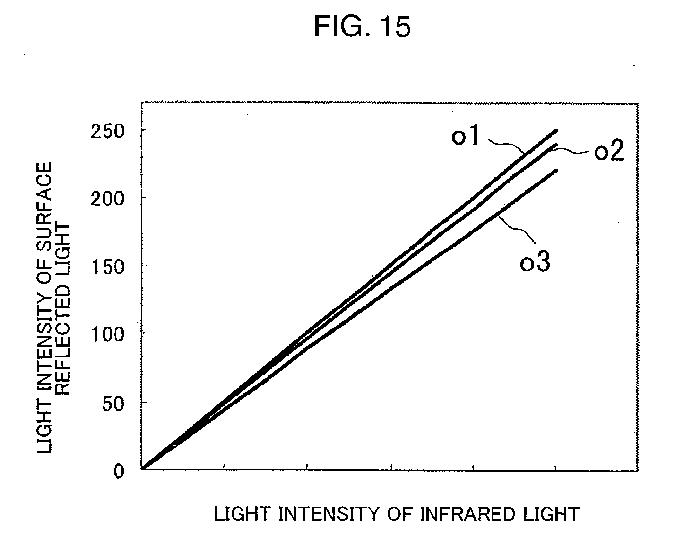

Fig. 15 is a graph showing the relation between light intensity of infrared light from the illumination device 5 and light intensity of the surface reflected light when the film thickness of cream solder is set to 50 µm (indicated by alpha-numeral reference o1), 80 µm (indicated by alpha-numeral reference o2), and 120 µm (indicated by alpha-numeral reference o3). As shown in Fig. 15, light intensity of the surface reflected light is in proportion to light intensity of infrared light irradiated to the cream solder, the value of which thus increases as the light intensity of infrared light becomes higher. In this manner, the value of light intensity of the surface reflected light can be specified from light intensity of infrared light to be irradiated and reflectance of the surface reflected light. Accordingly, reflectance of the surface reflected light is found in advance and the detection portion 95b detects the reflected components from the reflectance and light intensity of infrared light to be irradiated from the illumination device 5. It is sufficient to find the value of reflectance of the surface reflected light at least in a region corresponding to the cream solder. Accordingly, it may be configured in such a manner so as to find values across the entire region imaged by the image taking device 6.

When the reflected components are specified, the elimination portion 95c eliminates the reflected components from the cream solder surface from the image data (Step S6). The reflected components can be eliminated by the following two methods.

Initially, the elimination portion 95c eliminates the components of the surface reflected light from the image data by subtracting the value of light intensity corresponding to the surface reflected light from the value of light intensity of each pixel forming the image data. In this instance, it may be configured in such a manner so as to subtract light intensity of the corresponding surface reflected light from pixel to pixel forming the image data. This subtraction can be achieved by calculating reflectance of the surface reflected light of each pixel in advance. Consequently, it becomes possible to eliminate the components of the surface reflected light more precisely.

Alternatively, the detection portion 95b may detect a ratio of light intensity of the transmitted reflected light with respect to light intensity of each pixel forming the image data. In this case, the elimination portion 95c multiplies light intensities of all the pixels forming the image data by this ratio. The components of the surface reflected light can be eliminated from the image data also in this manner. In this case, too, the light intensity may be multiplied by the ratio of the light intensity of the transmitted reflected light pixel by pixel forming the image data. This multiplication can be achieved by calculating the ratio of the transmitted reflected light for each pixel in advance. Consequently, it becomes possible to eliminate the components of the surface reflected light more precisely.

It should be appreciated that elimination of the reflected components is not limited to the methods described above, and they may be eliminated by the following method. In this case, a board (hereinafter, referred to as the transmission board) made of a material that transmits infrared light, such as polyamide, on which neither electrodes nor wiring patterns are formed is prepared first. A calibration board is then formed by applying or printing cream solder, which is the same as the cream solder on a board subject to inspection on which an inspection will be performed by the inspecting apparatus 1, using a dispenser or a printing device. Herein, the cream solder to be applied or printed on the calibration board is formed at the same position in the same shape as the cream solder on the board subject to inspection.

When the calibration board is formed, the image taking portion 95a has the board be carried into the inspecting apparatus 1 to be disposed in the inspection work area provided almost at the center of the base stand 11. In this instance, an infrared absorbing member is provided above the table 30 that is beneath the calibration board. Owing to this configuration, infrared light having passed through the calibration board is absorbed into the infrared light absorbing member.

When the calibration board is disposed on the table 30, the image taking portion 95a activates the illumination device 5 to illuminate infrared light at light intensity identical to the light intensity of infrared light to be irradiated to the board subject to inspection and activates the image taking device 6 to take an image of the calibration board. An image including an image of the infrared light reflected on the surface layer of the cream solder is thus obtained. This image is recorded in the storage portion 96 as image data 96a.

When the image of the calibration board is obtained, the elimination portion 95c generates image data from which the components of the surface reflected light have been eliminated by subtracting the value of light intensity of pixels corresponding to the image of the calibration board from the value of light intensity of each pixel forming the image data obtained in Step S4. The components of the surface reflected light can be eliminated from the image data in this manner, too.

When the components of the surface reflected light are eliminated, the area calculation portion 95d in the main control portion 95 calculates the sectional area of the cream solder on the basis of the image data (Step S7). This calculation can be achieved on the basis, for example, of the characteristic diagram shown in Fig. 11. Specifically, brightness of pixels corresponding to the cross section is found on the basis of the film thickness of the cross section of the cream solder that needs to be detected on the basis of the inclination of a curve corresponding to light intensity of infrared light irradiated from the illumination device 5, and the number of pixels corresponding to the brightness is counted. Consequently, it becomes possible to detect the sectional area in a specific thickness. The characteristic diagram shown in Fig. 11 may be prepared in advance and stored, for example, in the storage portion 96.

When the sectional area of the cream solder is calculated, the determination portion 95e in the main control portion 95 determines whether the sectional area of the cream solder is equal to or larger than the predetermined value (Step S8). This determination can be made by comparing the sectional area of the cream solder calculated by the area calculation portion 95d with a pre-set threshold value. In a case where the sectional area is smaller than the threshold value, for example, because an amount of applied cream solder is small or an air bubble is present inside the cream solder, the determination portion 95e determines that the area of the cream solder is not equal to or larger than the predetermined value. By making a determination in this manner, it becomes possible to detect an insufficient amount of the cream solder or the presence of an air bubble.

In a case where the sectional area of the cream solder is equal to or larger than the predetermined value (Step S8: YES), the determination portion 95e activates the drive control portion 91 to drive the board transportation portion 2 and the table transportation portion 3, so that the board at the predetermined position on the table 30 is carried out to the outside of the inspecting apparatus 1 (Step S9). The board carried out to the outside of the inspecting apparatus 1 is carried into the mounting device 102 and electronic components are mounted thereon by the mounting device 102.

Meanwhile, in a case where the sectional area of the cream solder is not equal to or larger than the predetermined value (Step S8: NO), the determination portion 95e determines the cream solder as being non-conforming and activates the I/F portion 94 for driving the display device 7 to perform a warning operation (Step S10). Examples of the warning operation include but not limited to an operation to display a message informing the presence of non-conformity in the cream solder on the display 7a and an operation to light on a lamp indicating a warning in the signal tower 7b. Consequently, it becomes possible to prevent a board on which non-conforming cream solder is applied from being carried out.

As has been described, according to this embodiment, a state inside the cream solder can be detected as the illumination device 5 irradiates infrared light at the predetermined intensity to the board on which cream solder is applied for the image taking device 6 to take an image of the board to which the infrared light is irradiated, and the main control portion 95 of the control device 9 detects the sectional shape of the cream solder on the basis of the image indicating light intensity of the infrared light reflected on the board. It thus becomes possible to prevent a board on which non-conforming cream solder is applied from being carried out by carrying out the board or giving a warning according to a state inside the cream solder.

Also, according to this embodiment, because the surface reflected light can be eliminated by the elimination portion 95c, it is possible to detect the sectional shape of the cream solder more exactly.

In this embodiment, it is configured in such a manner that the reflected component detection portion 95b detects light intensity of the surface reflected light or a ratio of the surface reflected light from light intensity of infrared light to be irradiated from the illumination device 5. It should be appreciated, however, that the characteristic diagram as shown in Fig. 11 may be prepared in advance, so that light intensity or a ratio of the surface reflected light is detected from the characteristic diagram. In Fig. 11, an alternate long and short dash line h7 indicates that light intensity in a region below this line is the components of the surface reflected light. In other words, light intensity in the region above the alternate long and short dashed line h7 indicates brightness including both reflected light from the surface of cream solder and reflected light from the surface of the electrode pad. It thus becomes possible to detect light intensity of the surface reflected light or a ratio of the surface reflected light on the basis of the alternate long and short dash line h7 and the curves h1 through h6. The surface reflected light can be eliminated in this manner, too.

### First Modification

A first modification of the first embodiment will now be described. In this modification, a filter 61 is provided to the image taking device 6 of the first embodiment above. Accordingly, like components as those in the first embodiment above are referred to under the same names and labeled with like reference numerals and descriptions thereof are omitted herein where appropriate.

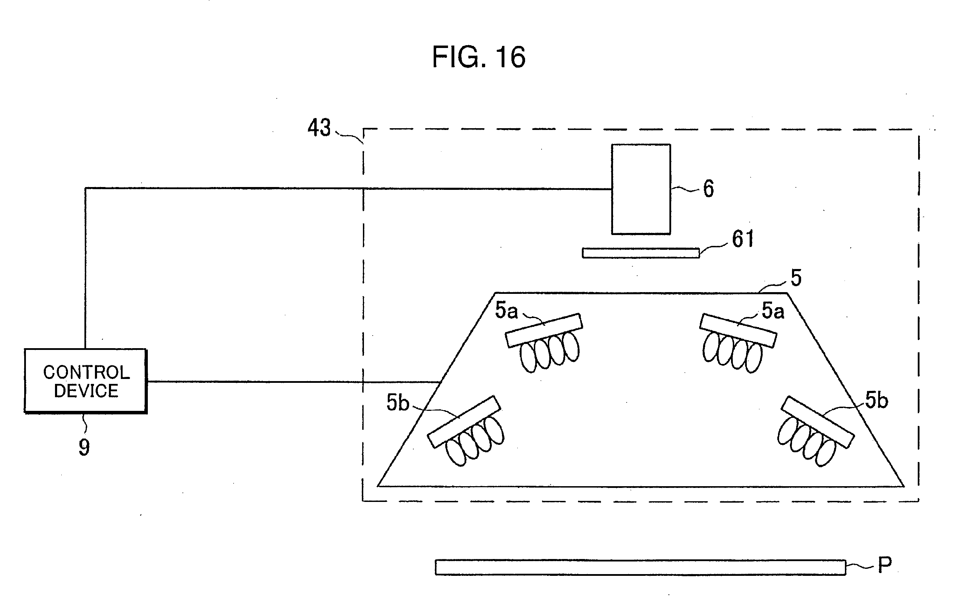

As shown in Fig. 16, the image taking device 6 is provided with the filter 61 in front of the taking plane. The filter 61 is comprised by a filter that does not transmit infrared light having light intensity identical to the light intensity of the surface reflected light. Accordingly, when the image taking device 6 takes an image of reflected light, which is infrared light irradiated from the illumination device 5 and reflected on the board, the surface reflected light is eliminated by the filter 61. It thus becomes possible to obtain a captured image excluding the surface reflected light.

As has been described, according to this modification, it becomes possible to prevent the image taking device 6 from taking an image of the surface reflected light by providing the filter 61. A state inside the cream solder can be thus detected more precisely.

Alternatively, the elimination portion 95c of the first embodiment above may be provided in this modification. In this case, the elimination portion 95c subtracts the value of light intensity corresponding to the surface reflected light from the value of light intensity of each pixel forming the image data on the basis of the captured image from which the surface reflected light has been eliminated by the filter 61 or multiplies light intensities of all the pixels forming the image data by the ratio of light intensity of the surface reflected light. Consequently, the surface reflected light can be eliminated from the image data in a more reliable manner.

### Second Modification

A second modification of the first embodiment above will now be described. In this modification, the attachment angles of the illumination device 5 and the image taking device 6 of the first embodiment above are changed. Accordingly, like components as those in the first embodiment above are referred to under the same names and labeled with like reference numerals and descriptions thereof are omitted herein where appropriate.

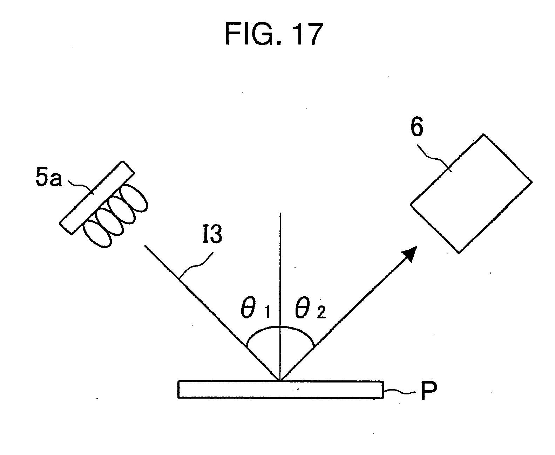

As shown in Fig. 17, the illumination device 5 and the image taking device 6 are disposed above the board P on the surface side and disposed on the opposite sides with an taking region on the board P to be imaged by the image taking device 6 in between, in other words, on the opposite sides with an axis perpendicular to the surface of the board P in between, in such a manner that each is diagonal with respect to the board P. Specifically, the illumination device 5 and the image taking device 6 are in a mirror relation with respect to the perpendicular axis. They are disposed in such a manner that an angle θ1 produced between the optical axis of the illumination device 5 and the perpendicular axis and an angle θ2 produced between the taking direction of the image taking device 6 and the perpendicular axis are equal.

Incidentally, so-called the surface reflected light and the transmitted reflected light have a difference as follows regarding the directions thereof. Most of the surface reflected light is reflected chiefly on the solder powder in the cream solder. Because the solder powder is of an almost spherical shape, the surface reflected light is emitted radially from the solder powder surface. The surface reflected light as a whole, however, includes many components that travel in a direction opposite to the direction in which the infrared light was irradiated. On the contrary, the transmitted reflected light is made up of components reflected on the electrode pad formed of a smooth metal layer on the board surface. The travel direction is therefore determined in accordance with so-called the law of reflection.

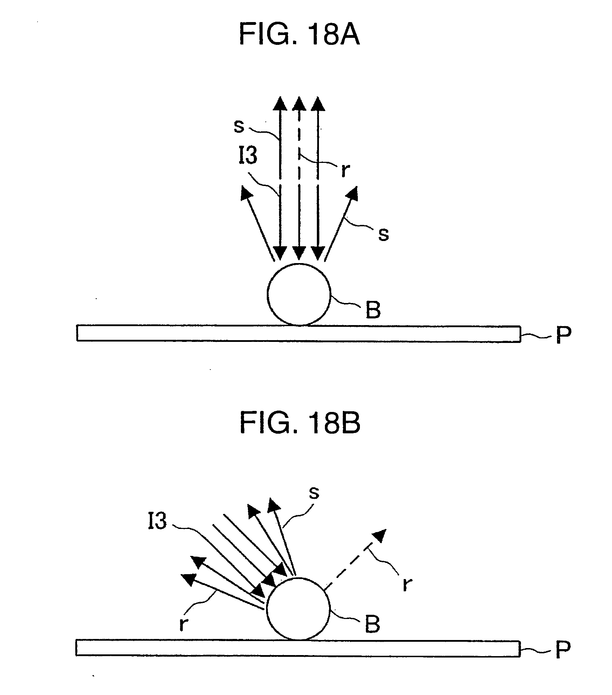

Accordingly, as shown in Fig. 18A, in a case where infrared light I3 is irradiated perpendicularly to the board P from the illumination device 5, both the surface reflected light s and the transmitted reflected light r travel along the perpendicular direction. Hence, when the infrared light I3 is irradiated to the board P in the perpendicular direction, both the transmitted reflected light r and the surface reflected light s travel in the same direction. The image taking device 6 therefore detects the transmitted reflected light r as well as the surface reflected light s.

On the contrary, as shown in Fig. 18B, in a case where the infrared light I3 is irradiated to the board P diagonally from the illumination device 5, the surface reflected light s travels chiefly toward the illumination device 5 in a direction opposite to the irradiation direction of the infrared light I3 whereas the transmitted reflected light r travels to the opposite side of the light source of the infrared light I3 at an angle of reflection, which is the same angle as the angle of incidence of the infrared light I3, in accordance with the law of reflection. Accordingly, by irradiating infrared light to the board diagonally, the travel direction of the transmitted reflected light r and the travel direction of the surface reflected light s can be differed from each other. Hence, by disposing the image taking device 6 on the same side as the illumination device 5 is provided with respect to the board and opposite to the illumination device 5 by the way of the taking region on the board surface, it becomes possible to take an image of the transmitted reflected light r alone.

In the case of Fig. 17, the infrared light I3 emitted from the illumination device 5 is irradiated to the board P at the angle of incidence, θ1. Meanwhile, of the infrared light I3 irradiated to the board P, infrared light having passed through the cream solder, that is, the transmitted reflected light, is reflected on the board P at the angle of reflection, θ2, so that an image thereof is taken by the image taking device 6. The image taking device 6 is thus able to take an image of the transmitted reflected light alone. As has been described, according to this embodiment, by providing the illumination device 5 and the image taking device 6 diagonally with respect to the board, it becomes possible to take an image of the transmitted reflected light alone because the surface reflected light does not travel toward the side where the image taking device 6 is provided. It thus becomes possible to acquire image data from which influences of the surface reflected light have been eliminated. Consequently, a state inside the cream solder can be detected more precisely.

Alternatively, the elimination portion 95c of the first embodiment above may be provided in this modification. In this case, the elimination portion 95c subtracts the value of light intensity corresponding to the surface reflected light from the value of light intensity of each pixel forming the image data on the basis of the image captured by the image taking device 6 that is provided diagonally with respect to the board or multiplies light intensities of all the pixels forming the image data by a ratio of light intensity of the surface reflected light. Consequently, influences of the surface reflected light can be eliminated from the image data in a more reliable manner.

Also, in this modification, the filter 61 of the first modification may be provided. In this case, upon detection of reflected light, which is infrared light irradiated from the illumination device 5 and reflected on the board, because the surface reflected light is eliminated by the filter 61, the image taking device 6 is able to obtain a captured image from which the surface reflected light has been eliminated in a more reliable manner.

Also, in this modification, the elimination portion 95c and the filter 61 may be provided. Consequently, because influences of the surface reflected light can be eliminated in a more reliable manner, it is possible to detect a state inside the cream solder more precisely.

### Second Embodiment

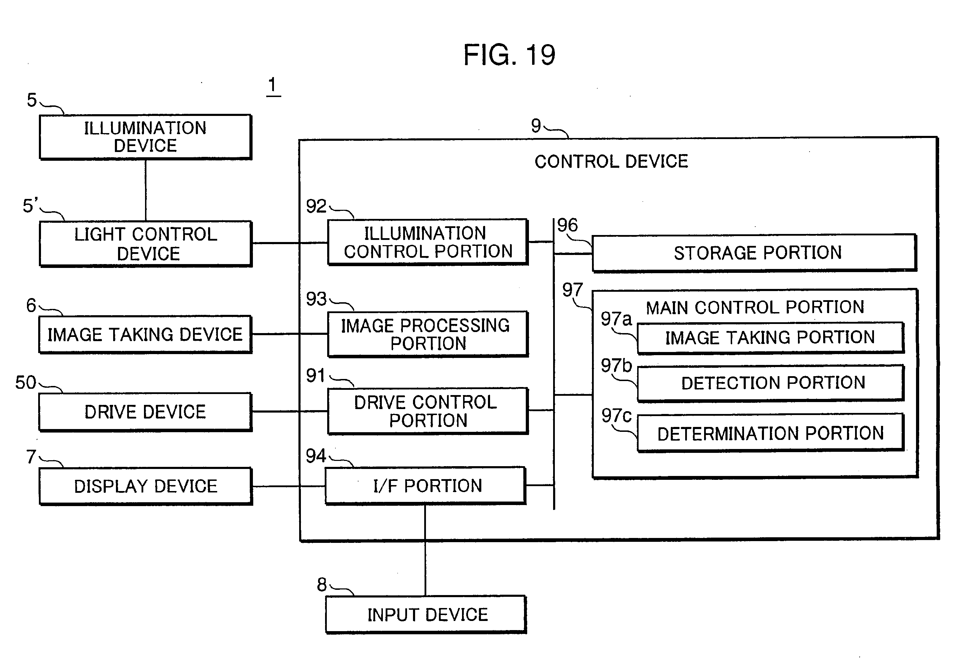

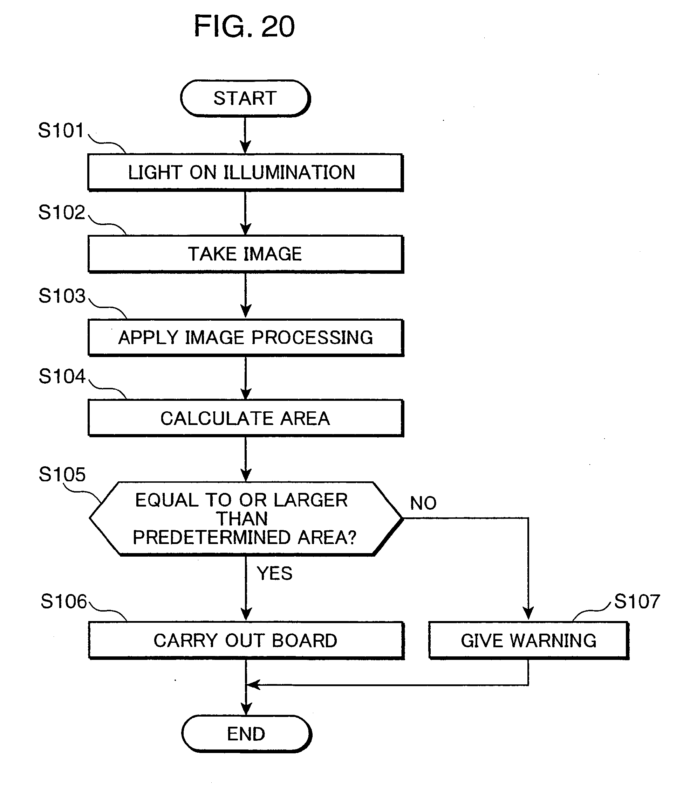

A second embodiment of the invention will be described with reference to Fig. 19 and Fig. 20. Because the mechanical configuration of an inspecting apparatus is the same as in the first embodiment above (see Fig. 1 and Fig. 2), illustrations thereof are omitted herein. In a block diagram of Fig. 19 showing a control device, portions furnished with like functions as those in the first embodiment above are labeled with like reference numerals and detailed descriptions thereof are omitted herein.

The second embodiment is more basic than the first embodiment above, and in this embodiment, too, an image is taken by the image taking device 6 while infrared light at the predetermined intensity is irradiated from the illumination device 5 to a board on which cream solder is applied, so that an image indicating the intensity distribution of infrared light reflected on the board is obtained. The reflected components from the surface of cream solder, however, are not eliminated in this embodiment.

### Configuration of Inspecting Apparatus

As shown in Fig. 19, the inspecting apparatus 1 of this embodiment includes an illumination device 5, a light control device 5' , an image taking device 6, a drive device 50, a display device 7, an input device 8, and a control device 9.

The illumination device 5, the image taking device 6, the display device 7, and the input device 8 are configured in the same manner as the respective counterparts of the first embodiment above. The light control device 5' is a device that supplies the supply voltage to the illumination device 5. The supply voltage is adjusted according to an instruction from the control device 9. Also, the drive device 50 corresponds to the board transportation portion 2, the table transportation portion 3, and the image taking device transportation portion 4 of the first embodiment above.

The control device 9 includes an illumination control portion 92, an image processing portion 93, a drive control portion 91, an I/F portion 94, a storage portion 96, and a main control portion 97. The illumination control portion 92, the image processing portion 93, the drive control portion 91, the I/F portion 94, and the storage portion 96 are configured in the same manner as the respective counterparts of the first embodiment above.

The main control portion 97 is a functional portion that achieves an inspection operation to inspect a state of the cream solder printed on the board by outputting instructions to the illumination control portion 92, the image processing portion 93, the drive control portion 91, and the I/F portion 94 according to an instruction from the outside, for example, from the user or a host computer. The main control portion 97 configured as above includes an image taking portion 97a that takes an image of the board on which cream solder is applied, a detection portion 97b that calculates the sectional area by detecting the sectional shape of the cream solder based on the image data, and a determination portion 97c that determines whether the cream solder is conforming or non-conforming on the basis of the calculated sectional area of the cream solder.

The image taking device 6, the image processing portion 93, and the image taking portion 97a in the main control portion 97 together form image obtainer for obtaining an image indicating the intensity distribution of infrared light reflected on the board P.

### Operation of Inspecting Apparatus

An inspection operation by the inspecting apparatus 1 of this embodiment will now be described with reference to Fig. 20.

Initially, upon acceptance of an instruction to start an inspection operation from the input device 8 or the host computer, the image taking portion 97a in the main control portion 97 activates the drive control portion 91 to carry in a board on which cream solder is applied to be fixed at the predetermined point in the inspecting apparatus 1. Then, it activates the illumination control portion 92 for driving the illumination device 5 to irradiate infrared light at the predetermined intensity to the board (Step S101). Herein, the intensity of infrared light is set as needed according to the thickness of cream solder applied on the board or the like. Intensity of infrared light may be stored in the storage portion 96 in advance. Also, information about the thickness of the cream solder can be acquired from the input device 7 or the host computer or from information stored in the storage portion 96.

When infrared light is irradiated, the image taking portion 97a activates the image processing portion 93 for driving the image taking device 6 to take an image of the board to which the infrared light is irradiated (Step S102).

When the image is captured by the image taking device 6, the image taking portion 97a activates the image processing portion 93 to apply image processing on the captured image and thereby to generate image data (Step S103). The image data thus generated may be stored in the storage portion 96.

When the image data is generated, the area calculation portion 97b in the main control portion 97 calculates the area of the cross section of the cream solder on the basis of the image data (Step S104). The area of the cross section of the cream solder is calculated, for example, by detecting the sectional shape of the cream solder from a direction parallel to the board on the basis of the intensity distribution of reflected light from the board, in particular, from the electrode pad, that is, brightness of pixels corresponding to the cream solder, and by counting the number of pixels corresponding to the cross section of the cream solder.

When the area of the cross section of cream solder is calculated, the determination portion 97c in the main control portion 97 determines whether the area of the cream solder is equal to or larger than the predetermined value (Step S105). The determination in Step S105 and processing in Step S106 and Step S107 in response to the determination result are the same as the processing, respectively, in Steps S8 through S10 (see Fig. 13) of the first embodiment above.

As has been described, according to this embodiment, it becomes possible to detect a state inside the cream solder without having to use an X-ray as in the related art by irradiating infrared light at the predetermined intensity to the board on which cream solder is applied to take an image of the board and by detecting the sectional shape of the cream solder on the basis of the image indicating the intensity distribution of infrared light reflected on the board. A reduction both in cost and size of the apparatus can be thus achieved. Consequently, it becomes possible to detect a state inside the cream solder more readily.

### Third Embodiment

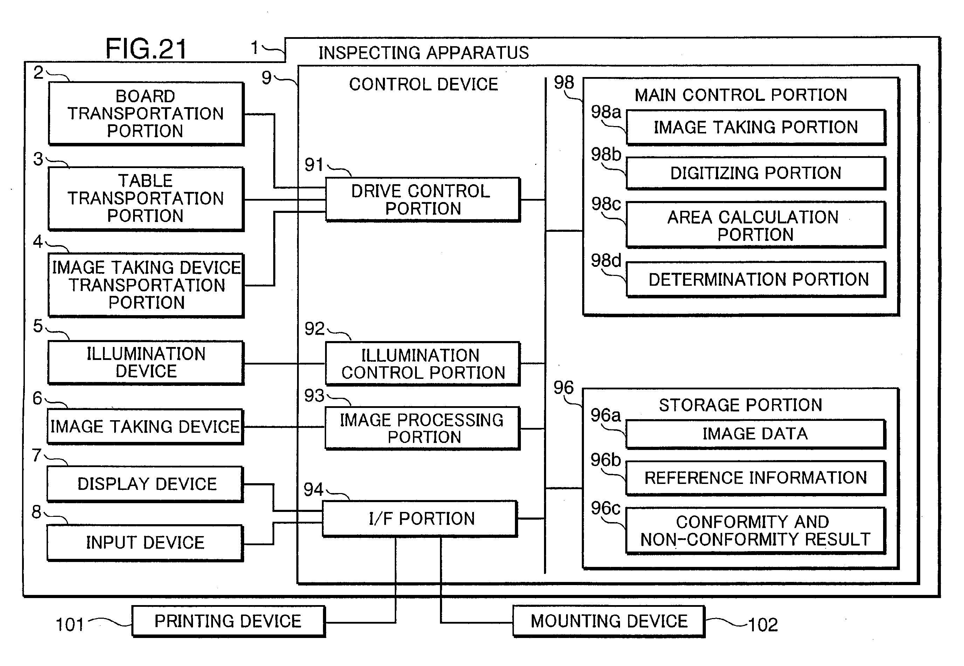

A third embodiment of the invention will be described with reference to Fig. 21 through Fig. 23. Because the mechanical configuration of an inspecting apparatus is the same as in the first embodiment above (see Fig. 1 and Fig. 2), illustrations thereof are omitted herein. In a block diagram of Fig. 21 showing a control device, portions furnished with like functions as those in the first embodiment above are labeled with like reference numerals and detailed descriptions thereof are omitted herein.

### Configuration of Inspecting Apparatus

As shown in Fig. 21, the control device 9 includes a drive control portion 91, an illumination control portion 92, an image processing portion 93, an I/F portion 94, a main control portion 98, and a storage portion 96. The drive control portion 91, the illumination control portion 92, the image processing portion 93, the I/F portion 94, and the storage portion 96 are configured in the same manner as the respective counterparts of the first embodiment above.

The main control portion 98 includes an image taking portion 98a controlled to take an image of a board on which cream solder is applied, a digitizing portion 98b that converts the image data into a binary form by comparing the image data with a predetermined threshold, an area calculation portion 98c that calculates the sectional area by detecting the sectional shape of the cream solder based on the image data converted into a binary form (hereinafter, referred to as the binary data), and a determination portion 98d that determines whether cream solder is conforming or non-conforming on the basis of the calculated sectional area of the cream solder.

The image taking device 6, the image processing portion 93, and the image taking portion 98a in the main control portion 98 together form image obtainer for obtaining an image indicating the intensity distribution of infrared light reflected on the board P.

### Operation Principle

It is possible to detect the sectional shape of the cream solder along a plane spaced apart from the board P according to the operation principle described in the first embodiment above.

For example, in a case where the cross section in the thickness X needs to be detected when infrared light at intensity corresponding to the curve h6 shown in Fig. 11 described above is irradiated to the board P on which cream solder is applied, it is possible to detect that pixels corresponding to the cross section in the thickness X are the pixels at brightness Y on the basis of the inclination of the curve h6. Hence, by detecting pixels at brightness Y or pixels at brightness Y or below, it becomes possible to detect the cross section in the thickness X.

In this instance, by converting the image data into a binary form, the shape of the cross section of the cream solder can be detected more exactly. In this case, brightness of pixels corresponding to a thickness that needs to be detected is found on the basis of the curves h1 through h6 corresponding to the intensity of infrared light irradiated from the illumination device 5 and the image data is converted into a binary form using the value thus found as the threshold value. Consequently, it becomes possible to acquire binary data representing the cross section of the cream solder in the predetermined thickness.

### Operation of Inspecting Apparatus

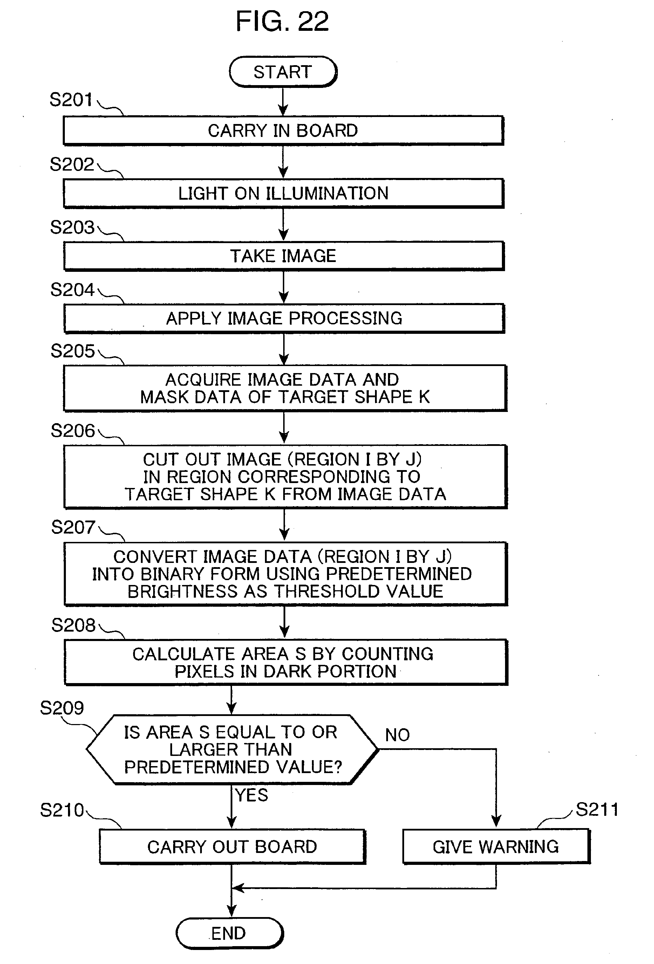

An inspection operation by the inspecting apparatus 1 of this embodiment will be now described with reference to Fig. 22.

Steps S201 through S204 are respectively the same as Steps S1 through S4 (see Fig. 13) of the first embodiment above. Image data in which light intensity of each pixel is expressed by gradation is generated by the processing to generate the image data in Step S204. Herein, the respective pixels of the image taking device 6 are aligned, for example, in a matrix fashion.

When the image data is generated, in order to covert the image data into a binary form using a predetermined threshold, the digitizing portion 98b in the main control portion 98 acquires the image data generated in the image taking portion 98a and mask data about a mask used in the printing device 101 when applying the cream solder onto the board whose image was taken (Step S205). The mask data includes information about the position and the shape of an opening in the mask, that is, the position and the shape of the cream solder applied on the board.

Upon acquisition of the image data and the mask data, the digitizing portion 98b cuts out image data of a region corresponding to the cream solder (target shape K) whose cross section is to be detected based on the image data generated by the image taking portion 98a (Step S206). The position of the target shape K is specified on the basis of the mask data and the image data in a region including the target shape K, for example, image data of a matrix with I rows and J columns of pixels can be acquired.

Having cut out the image data including the target shape K, the digitizing portion 98b converts the image data into a binary form using predetermined brightness as the threshold value (Step S207). Herein, the threshold value is set according to the thickness of the cross section of the cream solder that needs to be acquired on the basis, for example, of the characteristic diagram as shown in Fig. 11 described above. Hence, by changing the threshold value, it is possible to obtain binary data of cross sections in various thicknesses from one item of the image data.

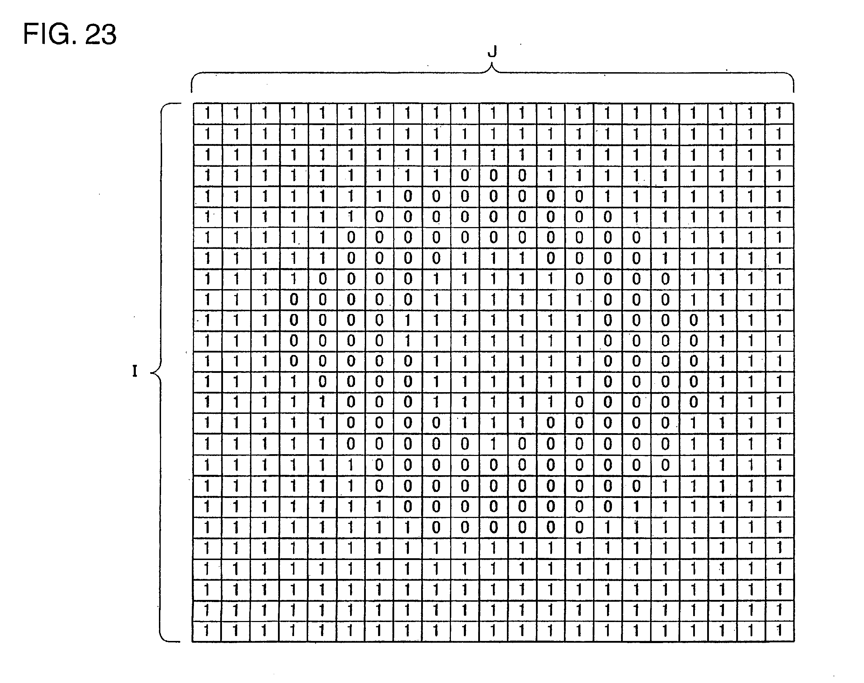

Binary data as shown in Fig. 23 is generated by converting the image data into a binary form using a predetermined threshold value. Fig. 23 shows binary image data aligned in a matrix with I rows and J columns (hereinafter, referred to as the region I by J) and the region I by J includes the target shape K. In each pixel, "1" indicates brightness at or higher than the threshold value and "0" indicates brightness lower than the threshold value. In other words, a boundary portion between the pixel exhibiting "1" and the pixel exhibiting "0" is a portion where the thickness of the cream solder is the predetermined thickness. A portion indicated by "0" is therefore a portion in the thickness equal to or thicker than the predetermined thickness. Hence, a portion corresponding to the pixels exhibiting "0" means the cross section of the cream solder in the predetermined thickness. By converting image data into a binary form using the threshold value in this manner, the rim of the sectional shape of the cream solder is shown more in detail, which can make the edge sharper. The sectional shape of the cream solder can be therefore determined more exactly.

When the data is converted into a binary form, the target region K within the region I by J, which is the cross section of the cream solder, becomes a dark portion indicated by "0". The digitizing portion 98b may activate the display device 7 to display the image data of the region I by J thereon. Consequently, the user becomes able to recognize the sectional shape of the cream solder more readily. It is therefore possible to determine whether the cream solder is conforming or non-conforming through visual inspection by the user.

The area calculation portion 98c in the main control portion 98 measures the area S of the cross section of the cream solder in the predetermined thickness by counting the number of pixels in the dark portion (Step S208). Specifically, the area calculation portion 98c counts the number of pixels in the dark portion within the image-converted region I by J. It thus becomes possible to measure the sectional area S of the cream solder in the predetermined thickness. The sectional area S of the cream solder may be measured after data conversion to convert the pixels exhibiting "1" in the region I by J to the dark portion (expressed by "0" on the data) and the pixels exhibiting "0" to a bright portion (expressed by "1" on the data) after the conversion into a binary form in Step S207. In this case, when the image data is displayed on the display device 7, the sectional portion of the cream solder is displayed bright and the rest portion is displayed dark. Even when configured in this manner, it is easy to make a determination on the cream solder through visual inspection. The sectional area S of the cream solder is measured by counting the number of pixels exhibiting "1" and corresponding to the cross section of the cream solder.

When the sectional area S of the cream solder is calculated, the determination portion 98d in the main control portion 98 determines whether the sectional area S of the cream solder is equal to or larger than a predetermined value (Step S209). This determination is made by comparing the sectional area S of the cream solder calculated by the area calculation portion 95c with a pre-set threshold value. In a case where the sectional area S is smaller than the threshold value, for example, because an amount of applied cream solder is small or an air bubble is present inside, the determination portion 98d determines that the area of the cream solder is not equal to the predetermined value or larger. When configured in this manner, it is possible to detect an insufficient amount of cream solder or the presence of an air bubble.

Processing in Step S210 and processing Step S211 in response to the determination result in Step S209 are respectively the same as the processing in Step S9 and Step S10 (see Fig. 13) in the first embodiment above.

As has been described above, according to this embodiment, it is possible to obtain an image in which the edge of the sectional shape of the cream solder is sharp by irradiating infrared light at the predetermined intensity from the illumination device 5 to the board on which cream solder is applied to take an image of the board to which the infrared light is irradiated by the image taking device 6, and by converting the image data indicating the intensity distribution of infrared light reflected on the board into a binary form using the predetermined threshold value by the digitizing portion 98b in the main control portion 98 of the control device 9, followed by measuring the sectional area of the cream solder along a plane spaced apart from the board on the basis of the image data converted into a binary form by the area calculation portion 98c in the main control portion 98. Consequently, a state inside the cream solder can be detected more precisely. It thus becomes possible to prevent a board on which non-conforming cream solder is applied from being carried out by carrying out the board or giving a warning according to a state inside the cream solder.

Also, according to this embodiment, because the threshold value is set according to the position of the sectional shape in the thickness direction of the cream solder, it becomes possible to detect the sectional shape of the cream solder in the predetermined thickness. Hence, a sectional shape in various thicknesses can be detected by merely changing the threshold value.

In this embodiment, it is configured in such a manner that whether the cream solder is conforming or non-conforming is determined on the basis of the sectional area of the cream solder. However, it may be configured in such a manner that whether the cream solder is conforming or non-conforming on the basis of the absence or presence of an air bubble inside cream solder or the sectional area of an air bubble. When configured in this manner, it is possible to determine whether the cream solder is conforming or non-conforming more in detail according to the type, a shape, and a size of the cream solder.

### Fourth Embodiment

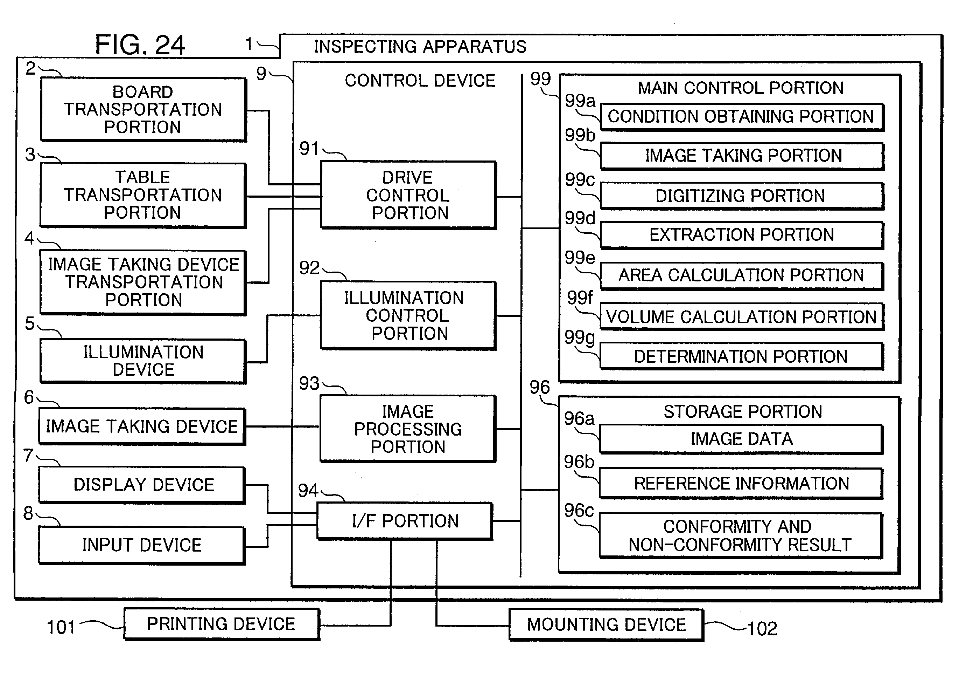

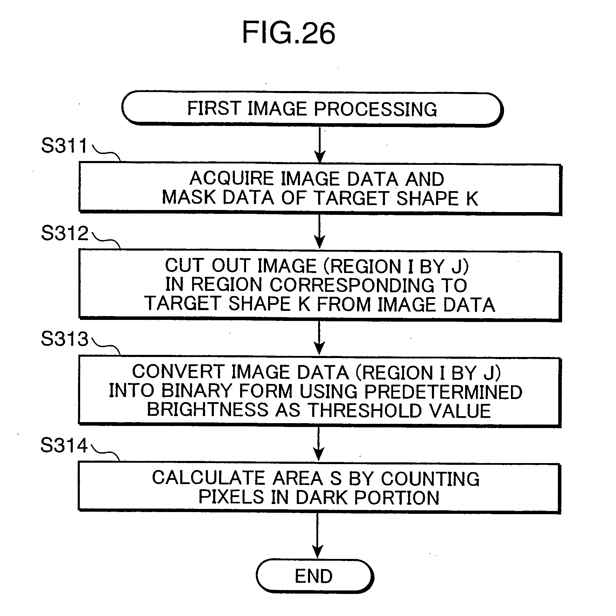

A fourth embodiment of the invention will be described with reference to Fig. 24 through Fig. 29. Because the mechanical configuration of an inspecting apparatus is the same as in the first embodiment above (see Fig. 1 and Fig. 2), illustrations thereof are omitted herein. In a block diagram of Fig. 24 showing a control system, portions furnished with like functions as those in the first embodiment above are labeled with like reference numerals and detailed descriptions thereof are omitted herein.

### Configuration of Inspecting Apparatus

As shown in Fig. 24, the control device 9 includes a drive control portion 91, an illumination control portion 92, an image processing portion 93, an I/F portion 94, a main control portion 99, and a storage portion 96. The drive control portion 91, the illumination control portion 92, the image processing portion 93, the I/F portion 94, and the storage portion 96 are configured in the same manner as the respective counterparts of the first embodiment above.

The main control portion 99 includes a condition obtaining portion 99a that obtains various conditions required for an inspection on the cream solder from the outside or the storage portion 96, an image taking portion 99b that activates the image taking device 6 to take an image of the board on which cream solder is applied, a digitizing portion 99c that converts primary image data into a binary form by comparing the primary image data with a predetermined threshold value, an extraction portion 99d that extracts a boundary line (contour line) (hereinafter, referred to as tertiary image data) between a bright portion and a dark portion from the image data converted into a binary form (hereinafter, referred to as the secondary image data), an area calculation portion 99e that calculates the sectional area by detecting the sectional shape of the cream solder on the basis of the secondary image data, a volume calculation portion 99f that calculates a volume of the cream solder on the basis of the calculated sectional area, and a determination portion 99g that determines whether the cream solder is conforming or non-conforming on the basis of the calculated sectional area or volume of the cream solder.

The image taking device 6, the image processing portion 93, and the image taking portion 99b in the main control portion 99 together form image obtainer for obtaining an image indicating the intensity distribution of infrared light reflected on the board P. Also, the digitizing portion 99c, the extraction portion 99d, the area calculation portion 99e, and the volume calculation portion 99f together form detector for detecting a three-dimensional shape of the cream solder using a plurality of items of image data from images that have been taken.

### Operation Principle

It is possible to detect the sectional shape of the cream solder along a plane spaced apart from the board P according to the operation principle described in the first embodiment above.

For example, in a case where a cross section in the thickness of X needs to be detected when infrared light at intensity corresponding to the curve h6 indicated in Fig. 11 described above is irradiated to the board P on which cream solder is applied, it is possible to detect that pixels corresponding the cross section in the thickness X are the pixels at brightness Y on the basis of the inclination of the curve h6. Accordingly, by detecting pixels at brightness Y or pixels at brightness Y or below, it is possible to detect the cross section in the thickness X. In this instance, by converting the image data into a binary form, it becomes possible to detect the shape of the cross section of the cream solder more exactly. In this case, brightness of pixels corresponding to the thickness that needs to be detected is found on the basis of the curves h1 through h6 (see Fig. 11) corresponding to intensity of infrared light irradiated from the illumination device 5, and the image data is converted into a binary form using the value thus found as the threshold value. Consequently, it becomes possible to acquire the secondary image data indicating the cross section of the cream solder in the predetermined thickness.

In addition, because the detectable thickness of the cross section varies with light intensity of infrared light, by taking images of the board on which cream solder is applied by changing light intensity of infrared light, it is possible to detect a plurality of cross sections each in a different slice thickness (height). In this manner, by obtaining a plurality of cross sections of the cream solder and displaying these cross sections mapped according to the respective heights, it becomes possible to display an approximated three-dimensional shape of the cream solder. In this instance, by increasing the number of cross sections of the cream solder to be obtained by taking images a larger number of times by changing light intensity of infrared light little by little, a more finely approximated three-dimensional shape of the cream solder can be displayed.

As has been described, the thickness of the cross section of the cream solder that is detectable from the primary image data varies with the threshold value used when converting the primary image data into a binary form or light intensity of infrared light. Hence, by taking an image more than once by changing intensity of infrared light while the threshold value used for conversion into a binary form is fixed, or changing the threshold value used for conversion into a binary form of the primary image data obtained while light intensity of infrared light to be irradiated is fixed to a predetermined value, or combining the foregoing methods, it becomes possible to obtain a plurality of items of the secondary image data each having a different thickness of the cross section of the cream solder. Consequently, a three-dimensional shape of the cream solder can be detected on the basis of these items of the secondary image data.

### Operation of Inspecting Apparatus

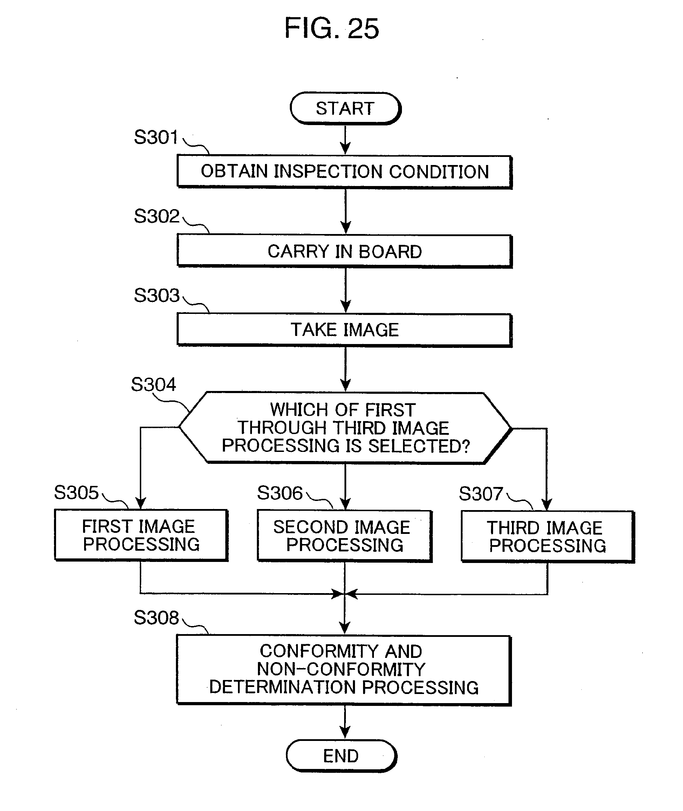

An inspection operation by the inspecting apparatus 1 of this embodiment will now be described with reference to Fig. 25.

Initially, the condition obtaining portion 99a in the main control portion 99 acquires various types of data required to inspect a state of the cream solder applied on the board (Step S301). Examples of the various types of data include but not limited to board data about the shape of the board and wiring patterns formed on the board, mask data about the shape of a mask used when printing cream solder onto the board, taking position and order data about the positions at which to take images of the board and the order thereof, inspection position data about the positions at which to carry out an inspection on the board, thickness data about the thickness of the cream solder to be detected, correlation data about the correlation among light intensity of infrared light to be irradiated from the illumination device 5, brightness of pixels to be detected, and the detectable height of the cross section of the solder, and image processing selection data about image processing to be selected. The foregoing data is acquired from the storage portion 96, the printing device 101, and host computer of the mounting line.

As has been described above, in order to acquire a plurality of items of the secondary image data, an image is taken more than once by changing light intensity of infrared light while the threshold value used for conversion into a binary form is fixed, the threshold value used for conversion into a binary form of the primary image data of one image taken while fixing light intensity of infrared light is changed, or these methods are combined. In the following, a case where a plurality of items of the secondary image data are acquired by taking an image more than once by changing light intensity of infrared light while the threshold value used for conversion into a binary form is fixed will be described by way of example. Hence, having obtained the inspection conditions, the condition obtaining portion 99a finds the number of image taking operations for each cream solder subject to inspection and the value of light intensity of infrared light to be irradiated from the illumination device 5 each time on the basis of the correlation data and the thickness data. The number of times data and the intensity data are correlated with each board to be inspected together with the taking position and order data, the inspection position data, and the image processing selection data. The correlated data is referred to as inspection data for ease of description.

When the inspection data is acquired, the image taking portion 99b activates the drive control portion 91 to drive the board transportation portion 2, so that the board on which cream solder is applied by the printing device 101 is carried in and disposed at the predetermined position on the table 30 (Step S302). When the board is carried in at the predetermined position, the image taking portion 99b activates the drive control portion 91 to drive the table transportation portion 3 and the image taking device transportation portion 4 according to the taking position and order data and the inspection position data, so that the image taking unit 4 is disposed above the cream solder subject to inspection on the board.

When the image taking unit 4 is disposed above the cream solder subject to inspection on the board, the image taking portion 99b activates the illumination device 5 to irradiate infrared light while changing intensity and activates the image taking device 6 to take images of the board at each intensity of infrared light irradiated from the illumination device 5 according to the inspection data (Step S303). Herein, the intensity of infrared light is set according to the intensity data. Also, an intensity of infrared light to be irradiated from the illumination device 5 and the number of image taking operations by the image taking device 6 are set according to the number of times data. Consequently, a plurality of images each taken with infrared light at different intensity irradiated to the board are captured.

It may be configured in such a manner that the image taking device 6 keeps taking images until all the taking positions on a single board are taken according to the taking position and order data. In this case, each image is taken according to the corresponding number of times data and intensity data. Also, captured images are stored in the storage portion 96 together with the corresponding taking positions and light intensity of infrared light. Image processing is applied to the captured images by the image processing portion 93 and the primary image data in which light intensity of each pixel is expressed by gradation is thus generated.

When the primary image data is generated, the main control portion 99 makes a selection as to which of first through third image processing will be performed according to the selection data (Step S304) and performs the selected image processing (Step S305 through S307). Each image processing will be described in the following.

### First Image Processing

The first image processing is a process to calculate the sectional area of the cream solder by converting the primary image data into a binary form. This processing is performed as in Steps S311 through S314 of Fig. 14.

Steps S311 through S314 are respectively the same as Steps S205 through S207 in the flowchart of Fig. 22 of the third embodiment above. Through these steps, not only the secondary image data converted into a binary form As shown in Fig. 23 described above is obtained, but also the area S is found by counting the number of pixels in the dark portion on the basis of the secondary image data.

### Second Image Processing

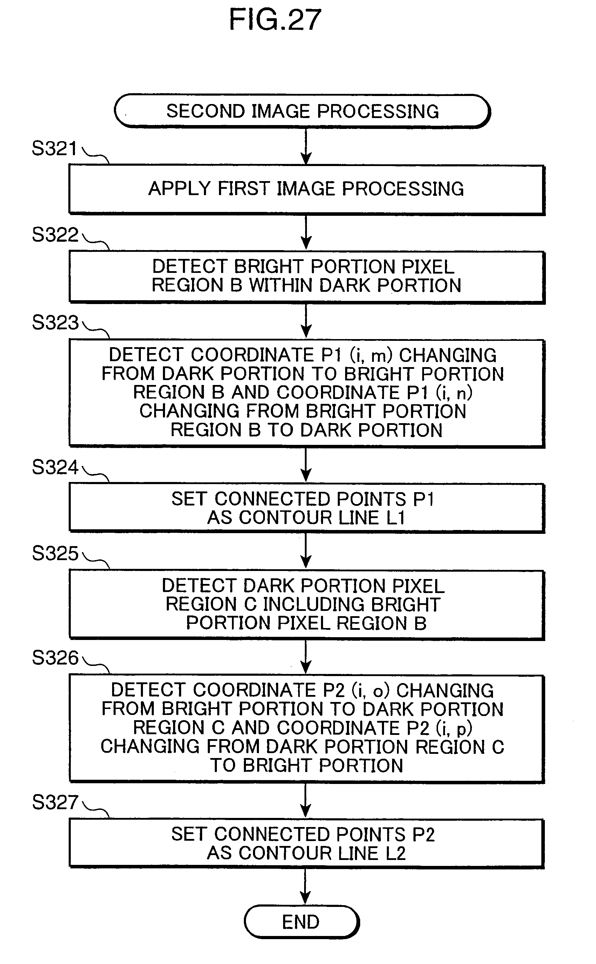

The second image processing is a process to detect tertiary image data indicating a boundary line between the bright portion and the dark portion on the basis of the secondary image data. This processing will be described with reference to Fig. 27.

Initially, the first image processing described above is performed by the digitizing portion 99c and the area calculation portion 99e (Step S321).

When the first image processing is performed, the extraction portion 99d detects a bright portion pixel region within the dark portion region included in the secondary image data (Step S322). For example, in the case of the region (I by J) of Fig. 23 described above, there is a region of pixels exhibiting "0" that indicate a dark portion within pixels exhibiting "1" on the outermost periphery that represent the electrode pad or the like and there is a region of pixels exhibiting "1" that represent an air bubble or the like and indicate a bright portion within these pixels exhibiting "0". The extraction portion 99d detects this bright portion region B. The bright portion region B can be detected by confirming the positional relation between the bright portion and the dark portion in the region (I by J), for example, by defining a bright portion closer to the center of the region (I by J) as the bright portion region B.

Having detected the bright portion region B, the extraction portion 99d detects a coordinate P1 (i, m) that changes from the region of pixels indicating the dark portion to the bright portion region B and a coordinate P1 (i, n) that changes from the bright portion region B to the region of pixels indicating the dark portion (Step S323). For example, in the case of the region (I by J) of Fig. 23, by changing a column J in each row I (for example, by moving it from left to right), the coordinate P1 (i, m) of a pixel that changes from the region of pixels indicating the dark portion to the bright portion region B and the coordinate P1 (i, n) of a pixel that changes from the bright portion region B to the region of pixels indicating the dark portion are detected in each row. Because the bright portion region B represents an air bubble inside the cream solder, the coordinates P1 mean the boundary between the cream solder and the air bubble.

Having detected the coordinates P1, the extraction portion 99d generates tertiary image data (contour line) L1 by connecting the coordinates P1 (Step S324). The contour line L1 made up of these continuous coordinates P1 represents the outer rim of the air bubble inside the cream solder.

Having set the contour line L1, the extraction portion 99d detects the dark portion pixel region within the bright portion region included in the secondary image data (Step S325). For example, in the case of the region (I by J) of Fig. 23, there are pixels exhibiting "0" that represent cream solder or the like and indicate the dark portion within the pixels exhibiting "1" on the outermost periphery that represent the electrode pad or the like and indicate the bright portion. The extraction portion 99d detects this dark portion region C. Accordingly, the bright portion region B is included in the dark portion region C. The dark portion region C can be detected by confirming the positional relation between the bright portion and the dark portion in the region (I by J), for example, by defining a dark portion closer to the center of the region (I by J) as the dark portion region C.

Having detect the dark portion region C, the extraction portion 99d detects a coordinate P2 (i, o) of a pixel that changes from the region of pixels indicating the bright portion to the dark portion region C and a coordinate P2 (i, p) of a pixel that changes from the dark portion region C to the region of pixels indicating the bright portion (Step S326). For example, in the case of the region (I by J) of Fig. 23, the coordinate P2 (i, o) that changes from the region of pixels indicating the bright portion to the dark portion region C and the coordinate P2 (i, p) that changes from the dark portion region C to the region of pixels indicating the bright portion are detected in each row by changing a column J in each row I (for example, by shifting it from left to right). Because the dark portion region C represents the cream solder on the electrode pad, the coordinate P2 indicates the boundary between the electrode pad and the cream solder in the cross section specified by the secondary image data.

Having detected the coordinates P2, the extraction portion 99d generates tertiary image data (contour line) L2 by connecting the coordinates P2 (Step S327). The contour line L2 made up of these continuous coordinates P2 represents the outer rim of the cream solder on the electrode pad.

By performing the second image processing as described above, it becomes possible to clearly detect the outer rim of the cream solder in the predetermined thickness or of an air bubble inside the cream solder.

Alternatively, it may be configured in such a manner that the area calculation portion 99e calculates the sectional area of the cream solder on the basis of the extracted tertiary image data (contour lines) L1 and L2. In this case, the sectional area can be calculated by counting the pixels within each of the contour lines L1 and L2 and finding a difference between the number of pixels within the contour line L2 and the number of pixels within the contour line L1. It thus becomes possible to calculate the sectional area of the cream solder more precisely.

### Third Image Processing

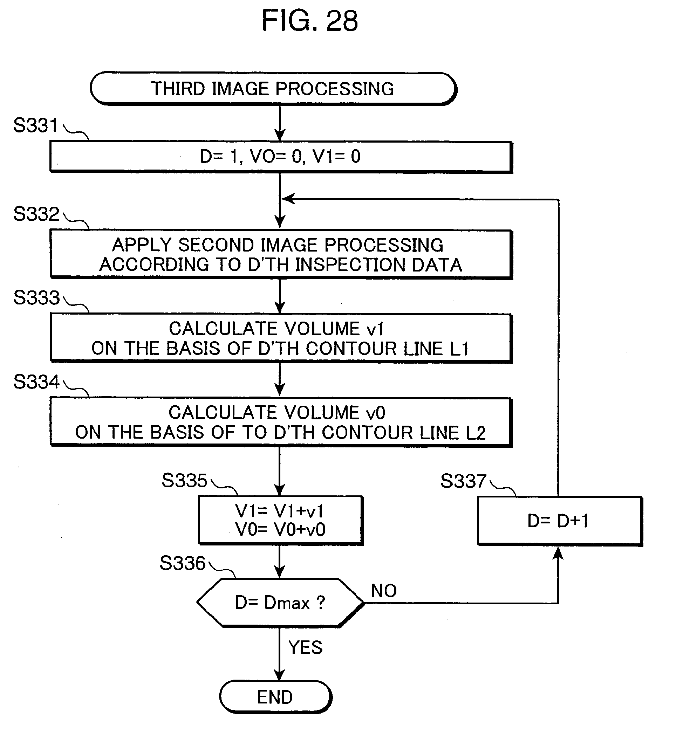

The third image processing is a process to acquire the secondary image data and the tertiary image data (contour lines), respectively, through the first image processing and the second processing described above and to detect a volume of the cream solder from the acquired image data. This processing will be described with reference to Fig. 28.

Initially, the volume calculation portion 99f sets a value D of the number of times data to 1, a volume V0 of an air bubble inside the cream solder to 0, and a volume V1 of the cream solder to 0 (Step S331).

Having set the values of D, V0, and V1, the volume calculation portion 99f activates the extraction portion 99d to perform the second image processing according to the inspection data corresponding to the value of the number of times data (Step S332). Consequently, the tertiary image data (contour lines) L1 and L2 on the basis of the secondary image data acquired at the D'th taking is calculated.

When the second image processing is performed, the volume calculation portion 99f calculates the volume v1 of an air bubble in the predetermined thickness on the basis of the calculated contour line L1 (Step S333). Specifically, the volume calculation portion 95f finds the area S1 within the contour line L1 first. The area S1 can be calculated by counting the pixels within the contour line L1. Subsequently, a height F from the secondary image data on the basis of the last taking, that is, the (D-1)'th taking, to the secondary image data on the basis of the taking of this time, that is, the D'th taking, is found. The height F represents a height in a direction perpendicular to the board and it can be found, for example, from the threshold value used by the digitizing portion 95c for conversion into a binary form or the characteristic diagram of Fig. 12. After the height F is found, the volume v1 is found by multiplying the height F by the area S1. The volume v1 means a volume of an air bubble in the height F. In a case of D = 1, the height F means a height from the board surface or the apex of the cream solder to the secondary image data on the basis of the D'th taking.

Having calculated the volume v1, the volume calculation portion 99f calculates a volume v0 of the cream solder in the predetermined thickness according to the calculated contour line L2 (Step S334). Specifically, the volume calculation portion 99f finds the area S within the contour line L2 first. The area S2 can be calculated by counting the pixels within the contour line L2. Subsequently, a difference S0 between S2 and S1 is found. The S0 represents the sectional area of the cream solder alone. Subsequently, a height F from the secondary image data on the basis of the last taking, that is, the (D-1)'th taking, to the secondary image data on the basis of the taking of this time, that is, the D'th taking, is found. The height F represents a height in a direction perpendicular to the board and it can be found, for example, from the threshold value used by the digitizing portion 99c for conversion into a binary form or the characteristic diagram of Fig. 11. When the height F is found, the volume v0 is found by multiplying the height F by the area S0. The volume v0 represents a volume of the cream solder in a thickness equal to the distance F. In a case where D = 1, the distance F represents a distance from the board surface or the apex of the cream solder to the secondary image data on the basis of the D'th taking.

Having calculated v1 and v0, the volume calculation portion 99f defines a value obtained by adding v1 to V1 as V1 and also defines a value obtained by adding v0 to V0 as V0 (Step S335). Consequently, the position of the cross section of the cream solder in the height direction corresponding to the value of the number of times data D and the volume of the cream solder in the thickness equal to the distance to the board surface or the apex of the cream solder or the volume of an air bubble are calculated as V1 or V0, respectively.

Having updated V1 and V0, the volume calculation portion 99f confirms whether the number of times data D has reached the maximum value (Step S336).

In a case where the value of the number of times data D has not reached the maximum value (Step S336: NO), the value of the number of times data D is incremented by one (Step S337) and the flow returns to the processing in Step S332. Meanwhile, the value of the number of times data D has reached the maximum value (Step S336: YES), the third image processing is ended.

By performing the third image processing as described above, it becomes possible to calculate the volume of the cream solder or of an air bubble inside the cream solder.

Alternatively, it may be configured in such a manner that the volume calculation portion 99f activates the display device 7 to display all the tertiary image data (contour lines) L1 and L2 extracted by the extraction portion 99d in a state where each is mapped on the corresponding height. Consequently, because an approximated three-dimensional shape including a state inside the cream solder can be displayed, the operator is able to confirm a state of the cream solder more specifically. In this instance, by increasing the value of the number of times data, more specifically, by acquiring a larger amount of the secondary image data, it becomes possible to display a more finely approximated three-dimensional shape of the cream solder.

### Conformity and Non-Conformity Determination Processing

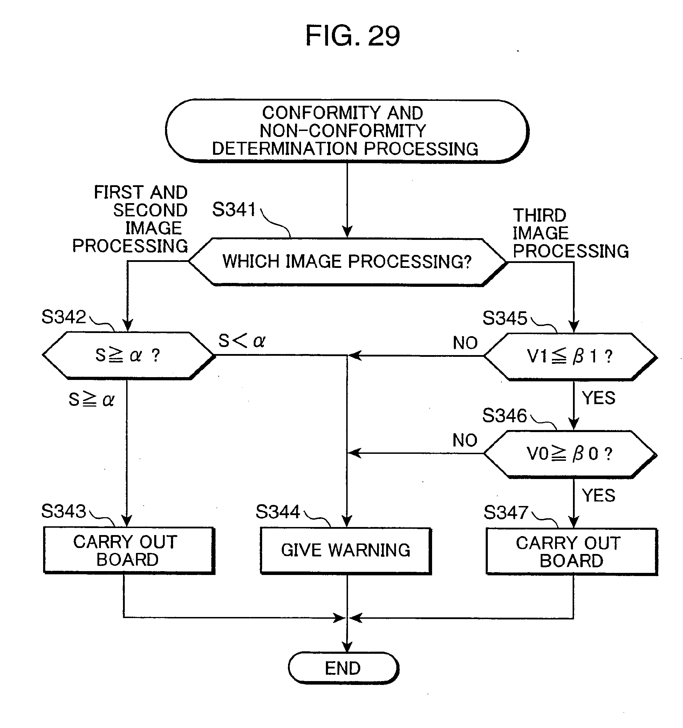

When the sectional area of the cream solder, the volume of the cream solder, the volume of an air bubble, and so forth are calculated by the first through third image processing described above, the determination portion 99g performs conformity and non-conformity determination processing to determine whether cream solder subject to inspection is conforming or non-conforming (Step S308). The conformity and non-conformity determination processing will be described with reference to Fig. 29.

Initially, the determination portion 99g confirms the image processing that has been performed (Step S341). In a case where the first or second image processing has been performed (Step S341: first and second image processing), the determination portion 99g determines whether the cream solder is conforming or non-conforming on the basis of the calculated sectional area of the cream solder. Meanwhile, in a case where the third image processing has been performed (Step S341: third image processing), the determination portion 99g determines whether the cream solder is conforming or non-conforming on the basis of the calculated volumes of the cream solder and an air bubble.

In a case where the first or second image processing has been performed, the determination portion 99g compares the value of the calculated sectional area S of the cream solder with a threshold value α, which is a predetermined value, and determines whether the sectional area S is equal to or larger than the threshold value α in order to determine whether the cream solder is applied appropriately (Step S342). According to this determination, the determination portion 99g determines that the area of the cream solder is not equal to or larger than the predetermined value in a case where the sectional area S is smaller than the threshold value α, for example, because an amount of applied cream solder is small or there is an air bubble inside the cream solder. When configured in this manner, it becomes possible to detect an insufficient amount of cream solder or the presence of an air bubble. Herein, in a case where more than one cross section is detected, the determination portion 99g may make a determination for each cross section. In this case, the threshold value α may be set for each height of the cross section. When configured in this manner, a more precise determination can be made. It should be noted that the threshold value α is set as needed according to the size and the shape of the cream solder, the height of cross section, and so forth.

In a case where the sectional area S of the cream solder is equal to or larger than the threshold value α (Step S342: YES), the determination portion 99g activates the drive control portion 91 to drive the board transportation portion 2 and the table transportation portion 3, so that the board at the predetermined position on the table 30 is carried out to the outside of the inspecting apparatus 1 (Step S343). The board carried out to the outside of the inspecting apparatus 1 is carried into the mounting device 102 and electronic components are mounted thereon by the mounting device 102.

Meanwhile, in a case where the sectional area S of the cream solder is not equal to or larger than the threshold value α (Step S342: NO), the determination portion 99g determines the cream solder as being non-conforming and activates the I/F portion 94 for driving the display device 7 to perform a warning operation (Step S344). Examples of the warning operation include but not limited to an operation to display a message informing the presence of non-conformity in the cream solder on the display 7a and an operation to light on a lamp indicating a warning in the signal tower 7b. Consequently, it becomes possible to prevent a board on which non-conforming cream solder is applied from being carried out.

In a case where the third image processing is performed, the determination portion 99g determines whether the calculated volume V1 of an air bubble inside the cream solder is equal to or smaller than a predetermined value β1 (Step S345). In a case where the volume V1 is larger than the threshold value β1, for example, because an air bubble inside the applied cream solder is large, the determination portion 99g determines the applied cream solder as being non-conforming. The threshold value β1 is set as needed according to the size and shape of the cream solder.

In a case where the volume V1 is equal to or smaller than the threshold value β1 (Step S345: YES), the determination portion 99g determines whether the calculated volume V0 of the cream solder is equal to or larger than a threshold value β0 (Step S346). In a case where the volume V0 is smaller than the threshold value β0, for example, because an amount of applied cream solder is small, the determination portion 99g determines the applied cream solder as being non-conforming. The threshold value β1 is set as needed according to the size and shape of the cream solder.

In a case where the volume V0 is equal to or larger than the threshold value β0 (Step S346: YES), the determination portion 99g activates the drive control portion 91 to drive the board transportation portion 2 and the table transportation portion 3, so that the board at the predetermined position on the table 30 is carried out to the outside of the inspecting apparatus 1 (Step S343). The board carried out to the outside of the inspecting apparatus 1 is carried into the mounting apparatus 102 and electronic components are mounted thereon by the mounting device 102.

Meanwhile, in a case where the volume V1 is larger than the threshold value β1 (Step S345: NO) or in a case where the volume V0 is smaller than the threshold value β0 (Step S346: NO), the determination portion 99g determines the cream solder as being non-conforming and activates the I/F portion 94 for driving the display device 7 to perform a warning operation (Step S344).

As has been described, according to this embodiment, a three-dimensional shape of the cream solder can be detected from a plurality of images each taken at different intensity of infrared light by irradiating a plurality of rays of infrared light each at different intensity from the illumination device 5 to the board on which cream solder is applied and taking images of the board to which infrared light is irradiated by the image taking device 6 for each intensity of infrared light. Consequently, it becomes possible to prevent a board on which non-conforming cream solder is applied from being carried out by carrying out the board or giving a warning according to a state inside the cream solder. In particular, because it is possible to detect the three-dimensional shape including the interior of the cream solder, the sectional shape of the cream solder can be recognized more specifically.

In this embodiment, a plurality of items of the secondary image data are acquired by taking an image more than once by changing light intensity of infrared light while the threshold value used for conversion into a binary form is fixed. However, it may be configured in such a manner that a plurality of items of the secondary image data are acquired by changing the threshold value used for conversion into a binary form of the primary image data of one image taken while light intensity of infrared light is fixed or by combining the method of taking an image more than once and the method of changing the threshold value. In these cases, in the first image processing, the inspection data in which the number and the value of the threshold value used for conversion into a binary form, or the number and the value of the threshold value used for conversion into a binary form and the number of image taking operations as well as light intensity of infrared light are correlated with each board subject to inspection together with the taking position and order data, the inspection position data, and the image processing selection data. In addition, the number of times data D in the third image processing is the order in which the threshold value used for conversion into a binary form is changed or the order in which the threshold used for conversion into a binary from and the number of image taking operations are changed. When configured in this manner, even in a case where the threshold value used for conversion into a binary form is changed or the method of taking an image more than once and the method of changing the threshold value are combined, a plurality of items of the secondary image data can be acquired. It is therefore possible to detect a three-dimensional shape of the cream solder or the like on the basis of the acquired secondary image data.

As has been described, an inspecting apparatus of the invention includes: illuminator for irradiating infrared light at predetermined intensity to a board on which cream solder is applied; image obtainer having image taking device for taking an image of the board to which the infrared light is irradiated for obtaining an image indicating an intensity distribution of infrared light reflected on the board; and detector for detecting a sectional shape or a three-dimensional shape of the cream solder based on the image.

According to the invention, it becomes possible to detect a state inside the cream solder without having to use an X-ray as in the related art, which can in turn reduce the cost and the size of the apparatus.

In the inspecting apparatus of the invention, it is preferable that the detector detects the sectional shape of the cream solder along a plane spaced apart from the board based on the image.

When configured in this manner, a state inside the cream solder can be detected by detecting the sectional shape of the cream solder.

Also, in the inspecting apparatus of the invention, it is preferable that the image obtainer obtains an image from which a reflected component from a surface of the cream solder has been eliminated to indicate the intensity distribution of the infrared light reflected on the board, and that the detector detects the sectional shape of the cream solder along the plane spaced apart from the board based on the image.

When configured in this manner, by detecting the sectional shape of the cream solder along the plane spaced apart from the board from the image from which the reflected component from the surface of the cream solder has been eliminated and indicating the intensity distribution of reflected light from the board, it becomes possible to detect a state inside the cream solder more precisely.

It is sufficient for the image obtainer to include the image taking device and eliminator for eliminating the reflected component from the surface of the cream solder from the image taken by the image taking device. Alternatively, the image obtainer may include the image taking device and a computing device for multiplying the image taken by the image taking device by a ratio of the reflected component from the board. Further, the image obtainer may include the image taking device and a filter that is provided between the image taking device and the board and does not transmit the reflected component from the surface of the cream solder.

Furthermore, the illuminator may be disposed to irradiate the infrared light diagonally to a surface of the board, and the image obtainer may include image taking device provided on a same side of the illuminator with respect to the board and on an opposite side with an taking region on the surface of the board in between for taking an image of the taking region diagonally with respect to the surface of the board.

Also, in the inspecting apparatus of the invention, it is preferable to further include digitizer for converting the image indicating the intensity distribution of the infrared light reflected on the board into a binary form using a predetermined threshold value, so that the detector detects the cross section of the cream solder along the plane spaced apart from the board based on the image converted into the binary form.

When configured in this manner, by converting the image indicating the intensity distribution of infrared light reflected on the board into a binary form using a predetermined threshold value, it becomes possible to obtain an image in which the edge of the sectional shape of the cream solder is sharp, which in turn makes it possible to detect a state inside the cream solder more specifically.

The digitizer may set the threshold value according to a position of the cross section in a thickness direction of the cream solder detected by the detector. Alternatively, the inspecting apparatus may further include display for displaying the cross section of the cream solder detected by the detector.

Also, the inspecting apparatus may further include determinator for determining a state of the cream solder on the basis of the sectional shape of the cream solder detected by the detector.

Also, in the inspecting apparatus of the invention, it is preferable that the detector detects the three-dimensional shape of the cream solder from a plurality of items of image data from images taken by the image taking device.

When configured in this manner, it is possible to detect the three-dimensional shape of the cream solder from an image obtained by taking images of the board to which infrared light is irradiated.

The detector may detect the three-dimensional shape of the cream solder on the basis the plurality of items of the image data, which are one of a plurality of items of secondary image data converted into a binary form using a predetermined threshold from a plurality of images each taken with the infrared light at different intensity, a plurality of items of secondary image data converted into a binary form using a plurality of threshold values from images taken by the image taking device to which the infrared light at the predetermined intensity is irradiated, and a plurality of items of secondary image data converted into a binary form using a plurality of threshold values from a plurality of images each taken with the infrared light at different intensity.

The detector may include extractor for extracting a boundary line between a dark portion and a bright portion for each item of the secondary image data, and calculator for calculating a volume of the cream solder on the basis of a plurality of boundary lines extracted by the extractor.

The inspecting apparatus may further include determinator for determining a state of the cream solder on the basis of the volume.

In addition, an inspecting method of the invention includes an illuminating step of irradiating infrared light at predetermined intensity to a board on which cream solder is applied, an image obtaining step of taking an image of the board to which the infrared light is irradiated to obtain an image indicating an intensity distribution of infrared light reflected on the board, and a detecting step of detecting a sectional shape or a three-dimensional shape of the cream solder based on the image.

In the method of the invention, it is sufficient in the detecting step to detect the sectional shape of the cream solder along a plane spaced apart from the board based on the image.

In the image obtaining step, an image may be obtained, from which a reflected component from a surface of the cream solder has been eliminated to indicate the intensity distribution of the infrared light reflected on the board, and in the detecting step, the sectional shape of the cream solder along the plane spaced apart from the board may be detected based on the image.

Also, the method may further include a digitizing step of converting the image indicating the intensity distribution of the infrared light reflected on the board into a binary form using a predetermined threshold value, so that, in the detecting step, the cross section of the cream solder along the plane spaced apart from the board is detected based on the image converted into the binary form.

In addition, in the detecting step, the three-dimensional shape of the cream solder may be detected from a plurality of items of image data detected from images that have been taken.

## Claims

1. An inspecting apparatus comprising:
an illuminator for irradiating infrared light at predetermined intensity to a board on which cream solder is applied;
an image obtainer having an image taking device for taking an image of the board to which the infrared light is irradiated for obtaining an image indicating an intensity distribution of infrared light reflected on the board; and
a detector for detecting a sectional shape or a three-dimensional shape of the cream solder based on the image.

2. The inspecting apparatus according to claim 1, wherein:
the detector detects the sectional shape of the cream solder along a plane spaced apart from the board based on the image.

3. The inspecting apparatus according to claim 1, wherein:
the image obtainer obtains an image from which a reflected component from a surface of the cream solder has been eliminated to indicate the intensity distribution of the infrared light reflected on the board; and
the detector detects the sectional shape of the cream solder along the plane spaced apart from the board based on the image.

4. The inspecting apparatus according to claim 3, wherein the image obtainer includes:
the image taking device; and
an eliminator for eliminating the reflected component from the surface of the cream solder from the image taken by the image taking device.

5. The inspecting apparatus according to claim 3, wherein the image obtainer includes:
the image taking device; and
a computing device for multiplying the image taken by the image taking device by a ratio of the reflected component from the board.

6. The inspecting apparatus according to claim 3, wherein the image obtainer includes:
the image taking device; and
a filter that is provided between the image taking device and the board and does not transmit the reflected component from the surface of the cream solder.

7. The inspecting apparatus according to claim 3, wherein:
the illuminator is disposed to irradiate the infrared light diagonally to a surface of the board; and
the image obtainer includes an image taking device provided on the same side as the illuminator is provided with respect to the board and opposite to the illuminator by the way of an taking region on the surface of the board, and adapted for taking an image of the taking region diagonally with respect to the surface of the board.

8. The inspecting apparatus according to claim 1, further comprising:
a digitizer for converting the image indicating the intensity distribution of the infrared light reflected on the board into a binary form using a predetermined threshold value,
wherein the detector detects the cross section of the cream solder along the plane spaced apart from the board based on the image converted into the binary form.

9. The inspecting apparatus according to claim 8, wherein:
the digitizer sets the threshold value according to a position of the cross section in a thickness direction of the cream solder detected by the detector.

10. The inspecting apparatus according to claim 8, further comprising:
a display for displaying the cross section of the cream solder detected by the detector.

11. The inspecting apparatus according to any one of claims 2 through 10, further comprising:
a determinator for determining a state of the cream solder on the basis of the sectional shape of the cream solder detected by the detector.

12. The inspecting apparatus according to claim 1, wherein:
the detector detects the three-dimensional shape of the cream solder from a plurality of items of image data from images taken by the image taking device.

13. The inspecting apparatus according to claim 12, wherein:
the detector detects the three-dimensional shape of the cream solder from the plurality of items of the image data which are one of a plurality of items of secondary image data converted into a binary form using a predetermined threshold from a plurality of images each taken with the infrared light at different intensity, a plurality of items of secondary image data converted into a binary form using a plurality of threshold values from images taken by the image taking device to which the infrared light at the predetermined intensity is irradiated, and a plurality of items of secondary image data converted into a binary form using a plurality of threshold values from a plurality of images each taken with the infrared light at different intensity.

14. The inspecting apparatus according to claim 13, wherein the detector includes:
an extractor for extracting a boundary line between a dark portion and a bright portion for each item of the secondary image data; and
a calculator for calculating a volume of the cream solder from a plurality of boundary lines extracted by the extractor.

15. The inspecting apparatus according to claim 14, further comprising:
a determinator for determining a state of the cream solder on the basis of the volume.

16. An inspecting method comprising:
an illuminating step of irradiating infrared light at predetermined intensity to a board on which cream solder is applied;
an image obtaining step of taking an image of the board to which the infrared light is irradiated to obtain an image indicating an intensity distribution of infrared light reflected on the board; and
a detecting step of detecting a sectional shape or a three-dimensional shape of the cream solder based on the image.

17. The inspecting method according to claim 16, wherein:
in the detecting step, the sectional shape of the cream solder along a plane spaced apart from the board is detected based on the image.

18. The inspecting method according to claim 16, wherein:
in the image obtaining step, an image is obtained, from which a reflected component from a surface of the cream solder has been eliminated to indicate the intensity distribution of the infrared light reflected on the board; and
in the detecting step, the sectional shape of the cream solder along the plane spaced apart from the board is detected based on the image.

19. The inspecting method according to claim 16, further comprising:
a digitizing step of converting the image indicating the intensity distribution of the infrared light reflected on the board into a binary form using a predetermined threshold value,
wherein, in the detecting step, the cross section of the cream solder along the plane spaced apart from the board is detected based on the image converted into the binary form.

20. The inspecting method according to claim 16, wherein:
in the detecting step, the three-dimensional shape of the cream solder is detected based on a plurality of items of image data of the images that have been taken.
